# EUROPEAN PATENT APPLICATION

(11) **EP 4 722 089 A1**
(43) Date of publication of application: **08.04.2026**
(21) Application number: 25207007.3
(22) Date of filing: 06.10.2025
(51) Int. Cl.: B62J 45/41, B62J 45/42, B62K 25/00, G01R 33/07

(54) **POSITION DETECTION DEVICE FOR A BICYCLE**

(30) Priority: 04.10.2024 US 202463703562 P; 29.09.2025 US 202519343912
(71) Applicant: SRAM, LLC., Chicago, IL 60607 (US)
(72) Inventor: SCHOOLCRAFT, R Joe, Colorado Springs, 80907 (US); BLAKESLEE, Sarah, Colorado Springs, 80907 (US); MCGEE, Alex, Colorado Springs, 80907 (US); DUNLAP, Charles, Colorado Springs, 80907 (US)
(74) Representative: Thum, Bernhard

(57) **Abstract**

A position detection device for a bicycle may include a bicycle component defining an interior and an exterior. A detectable element may be disposed in the interior of the bicycle component and movable relative to the bicycle component. At least one detecting element is disposed in the exterior of the bicycle component, the at least one detecting element operable to detect: a first position of the detectable element relative to the bicycle component, and a second position of the detectable element relative to the bicycle component, wherein the second position is different from the first position.

## Description

This application claims the benefit of U.S. Provisional Patent Application 63/703,562, filed October 4, 2024, which is hereby incorporated by reference in its entirety.

### FIELD

The present disclosure relates to bicycle components, and more specifically to position detection devices for bicycles.

### BACKGROUND

Bicycles are known to have movable components. Movable components include brakes, suspension, height-adjustable seatposts, and the like. Measurement of these components can provide useful feedback on how the components are functioning. Braking components may be movable throughout various positions corresponding to lever throw, brake pad position, braking force, and more. Suspension components may be movable throughout various positions corresponding to shaft position, wheel travel, and more. To provide feedback for tuning and control, accurate position detection of bicycle components is desired.

As such, there is a need for bicycle components that facilitate position detection throughout various modes of operation.

### SUMMARY

An object of this disclosure is to describe various position detection devices for bicycles. Position detection devices may be employed to provide data to riders and tuners. For example, position detection devices may be provided to determine positions of a braking component during operation, generating positional information related to operation of the brakes. Such braking positional information may be used for brake tuning purposes, to control other components such as suspension, and/or to control a drive motor as in an electrically assisted bicycle or e-bike. Positional data may be generated at sufficiently close time intervals to determine useful speed data of changes in position. For example, a height-adjustable seatpost may be measured to determine if an extension speed is indicative of a need for servicing. Detailed positional data may be used to map positions, speeds, accelerations, and more of various components. For example, suspension components may be mapped with respect to average position, minimum position, maximum position, minimum speed, maximum speed, minimum acceleration, maximum acceleration, and various other aspects. Accurate and fast position detection of bicycle components as described herein is used as a foundation of bicycle setup guidance and confirmation and may further be used to provide useful ride data to a rider and even a broader community the rider chooses.

One aspect provides a position detection device for a bicycle, the position detection device comprising: a bicycle component defining an interior and an exterior; a detectable element disposed in the interior of the bicycle component, the detectable element movable relative to the bicycle component; at least one detecting element disposed in the exterior of the bicycle component, the at least one detecting element operable to detect: a first position of the detectable element relative to the bicycle component, and a second position of the detectable element relative to the bicycle component, wherein the second position is different from the first position.

Another aspect provides a position detection device for a bicycle, the position detection device comprising: a bicycle component defining an interior and an exterior; a field generating element disposed on the interior of the bicycle component and generating a field detectable in the exterior of the bicycle component; and at least one detecting element disposed in the exterior of the of the bicycle component operable to detect the field generated by the field generating element.

Yet another aspect provides a position detection device for a bicycle, the position detection device comprising: a first component; a detectable element disposed on the first component; a second component movable along an axis relative to the first component throughout a travel range; a first detecting element disposed on the second component, the first detecting element operable to detect the detectable element during a first portion of the travel range; and a second detecting element disposed on the second component, the second detecting element operable to detect the detectable element during a second portion of the travel range distinct from the first portion of the travel range.

Yet another aspect provides a suspension component for a bicycle, the suspension component comprising: a first tube defining a first tube volume; a second tube disposed at least in part within the first tube volume, the second tube defining a second tube volume; a detectable element fixed relative to the second tube and disposed at least in part within the first tube volume; and at least one detecting element disposed external to the first tube volume and the second tube volume.

Yet another aspect provides a method for detecting positions of a bicycle component, the method comprising: moving a detectable element along a travel path between a first position and a second position; generating, with a first detecting element, a first output based on movement of the detectable element from the first position to the second position; generating, with a second detecting element, a second output, different from the first output, based on movement of the detectable element from the first position to the second position; and determining, with a processor, positional data based on the first output and the second output.

### BRIEF DESCRIPTION OF THE DRAWINGS

FIG. 1 is a side view of an example bicycle that can employ any of the position detection devices described herein.
FIG. 2 is a schematic view of an example position detection device in a first position.
FIG. 3 is a schematic view of the position detection device of FIG. 2 in a second position.
FIG. 4 is a schematic view of the position detection device of FIG. 2 in a third position.
FIG. 5 is a graph illustrating outputs of the position detection device shown in FIGS. 2-4.
FIG. 6 is another graph illustrating further outputs of the position detection device shown in FIGS. 2-4.
FIG. 7 is a perspective view of a suspension component that can employ any of the position detection devices described herein.
FIG. 8 is an enlarged sectional view of the suspension component of FIG. 7.
FIG. 9 is a sectional view of another position detection device that may be employed with the suspension component of FIG. 7.
FIG. 10 is a sectional view of yet another position detection device that may be employed with the suspension component of FIG. 7.
FIG. 11 is a sectional view of yet another position detection device that may be employed with the suspension component of FIG. 7.
FIG. 12 is a sectional view of yet another position detection device that may be employed with the suspension component of FIG. 7.
FIG. 13 is an exploded view of the position detection device and associated components of FIG. 12.
FIG. 14 is a perspective view of yet another position detection device that may be employed with the suspension component of FIG. 7.
FIG. 15 is another perspective view of the position detection device of FIG. 14.
FIG. 16 is a sectional view of the position detection device of FIG. 14 taken along cut line *16-16* in FIG. 14.
FIG. 17 is a perspective view of a brake component that can employ any of the position detection devices described herein.
FIG. 18 is a rear elevation view of a suspension component that can employ any of the position detection devices described herein.
FIG. 19 is a side view of the suspension component of FIG. 18.
FIG. 20 is a sectional view of the suspension component of FIG. 18 taken along cut line *20-20* in FIG. 18.
FIG. 21 is an enlarged sectional view of the suspension component of FIG. 18 as indicated by callout 21 in FIG. 20.
FIG. 22 is a sectional view of the suspension component of FIG. 18 taken along cut line 22-22 in FIG. 19.
FIG. 23 is a first side view of a suspension component that can employ any of the position detection devices described herein.
FIG. 24 is a second side view of the suspension component of FIG. 23.
FIG. 25 is a sectional view of the suspension component of FIG. 23 taken along cut line 25-25 in FIG. 24.
FIG. 26 is a first side view of a suspension component that can employ any of the position detection devices described herein.
FIG. 27 is a second side view of the suspension component of FIG. 26.
FIG. 28 is a sectional view of the suspension component of FIG. 26 taken along cut line *28-28* in FIG. 26.
FIG. 29 is an enlarged sectional view of the suspension component of FIG. 26 as indicated by callout 29 in FIG. 28.
FIG. 30 is another sectional view of the suspension component of FIG. 26 taken along cut line *30-30* in FIG. 27.
FIG. 31 is a flow chart of a method for detecting positions of a bicycle component.

The figures may not be to scale. Instead, the thickness of the layers or regions may be enlarged in the drawings. In general, the same reference numbers will be used throughout the drawing(s) and accompanying written description to refer to the same or like parts.

Other aspects and advantages of the embodiments disclosed herein will become apparent upon consideration of the following detailed description, wherein similar or identical structures may have similar or identical reference numerals.

### DETAILED DESCRIPTION

Reference will now be made in detail to present embodiments of the invention, one or more examples of which are illustrated in the accompanying drawings. The detailed description uses numerical and letter designations to refer to features in the drawings. Like or similar designations in the drawings and description have been used to refer to like or similar parts of the invention.

The word "exemplary" is used herein to mean "serving as an example, instance, or illustration." Any implementation described herein as "exemplary" is not necessarily to be construed as preferred or advantageous over other implementations.

The descriptors used herein, including the terms "first", "second", "third", etc. may be used interchangeably to distinguish one component from another and are not intended to signify location or importance of the individual components. Unless otherwise specified or understood based on their context of use, such descriptors are not intended to impute any meaning of priority or ordering in time but merely as labels for referring to multiple elements or components separately for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for ease of referencing multiple elements or components.

The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms, such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 1, 2, 4, 10, 15, or 20 percent margin.

Here and throughout the specification and claims, range limitations are combined and interchanged, such ranges are identified and include all the sub-ranges contained therein unless context or language indicates otherwise. For example, all ranges disclosed herein are inclusive of the endpoints, and the endpoints are independently combinable with each other.

Various suspension components may be provided with reference to the following disclosure. For example, front suspension forks, rear suspension shocks, seatposts, and various other suspension components are contemplated in connection with the features that follow. Proceeding with the example of front suspension on a bicycle, a front fork typically includes a crown, a steerer tube extending upward from the crown, and two legs extending downward from the crown. Each leg has an upper tube that is connected to the crown and a lower tube that is to be connected to the front wheel. The upper and lower tubes are arranged in a telescopic relationship. In some instances, a damper is disposed in one of the legs and a spring (e.g., an air spring, a coil spring) is disposed in the other leg. The spring enables the front fork to compress or contract when riding over a bump or obstacle, thereby reducing the transmission of shocks and vibrations to the rider, and then returns the fork to an expanded state after the compressive force is removed. In an air spring, pressures contained within a suspension component may be dangerous if suddenly released.

Suspension components on a bicycle may employ a position detection device. Position detection devices as described herein may be operable to measure a travel position of various suspension components. Such travel measurement may be performed once, for example to aid pre-ride setup; periodically, for example to confirm measurements throughout a ride; or continuously, for example to track and report travel derivatives such as suspension speed and acceleration. It is desirable that position detection is achieved without interfering with suspension operation. For example, position detection devices may advantageously be provided to wirelessly detect positions of suspension components.

Disclosed herein are example suspension components with position detection devices. In various examples, position detection devices as described herein may be operable to measure travel of suspension components. Position detection devices may be wirelessly implemented, for example communicating across one or more elements of a suspension components. Position detection devices generally may detect, store, and communicate suspension position data as described in this document.

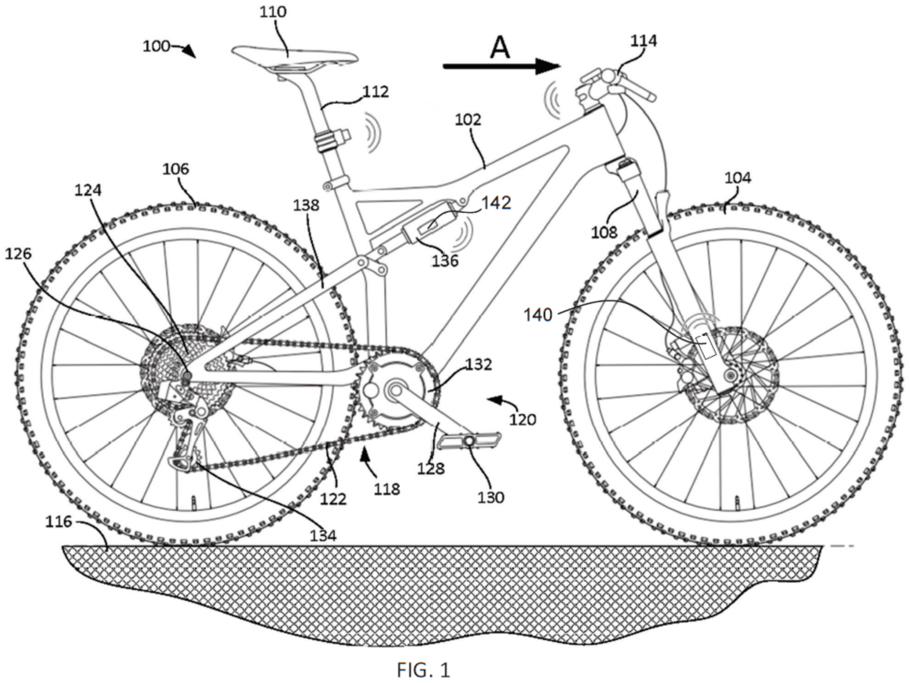

Turning now to the figures, FIG. 1 illustrates one example of a human powered vehicle on which the example front forks disclosed herein may be implemented. In this example, the vehicle is one possible type of bicycle 100, such as a mountain bicycle. In the illustrated example, the bicycle 100 includes a frame 102 and a front wheel 104 and a rear wheel 106 rotatably coupled to the frame 102. In the illustrated example, the front wheel 104 is coupled to the front end of the frame 102 via a front fork 108. A front and/or forward riding direction or orientation of the bicycle 100 is indicated by the direction of the arrow A in FIG. 1. As such, a forward direction of movement for the bicycle 100 is indicated by the direction of arrow A.

In the illustrated example of FIG. 1, the bicycle 100 includes a seat 110 coupled to the frame 102 (e.g., near the rear end of the frame 102 relative to the forward direction A) via a seatpost 112. The bicycle 100 also includes handlebars 114 coupled to the front fork 108 (e.g., near a forward end of the frame 102 relative to the forward direction A) for steering the bicycle 100. The bicycle 100 is shown on a riding surface 116. The riding surface 116 may be any riding surface such as the ground (e.g., a dirt path, a sidewalk, a street, etc.), a man-made structure above the ground (e.g., a wooden ramp), and/or any other surface.

In the illustrated example, the bicycle 100 has a drivetrain 118 that includes a crank assembly 120. The crank assembly 120 is operatively coupled via a chain 122 to a sprocket assembly 124 mounted to a hub 126 of the rear wheel 106. The crank assembly 120 includes at least one, and typically two, crank arms 128 and pedals 130, along with at least one front sprocket, or chainring 132. A rear gear change device 134, such as a derailleur, is disposed at the rear wheel 106 to move the chain 122 through different sprockets of the sprocket assembly 124. Additionally or alternatively, the bicycle 100 may include a front gear change device (not shown) to move the chain 122 through gears on the chainring 132.

The example bicycle 100 includes a suspension system having one or more suspension components. The front fork 108 is or integrates a shock absorber that includes a spring and a damper, disclosed in further detail herein. Further, in the illustrated example, the bicycle 100 includes a rear suspension component 136, which is a shock absorber, referred to herein as the rear shock absorber 136. The rear shock absorber 136 is coupled between two portions of the frame 102, including a rear triangle, also referred to herein as a swing arm 138 coupled to the rear wheel 106. The front fork 108 and the rear shock absorber 136 absorb shocks and vibrations while riding the bicycle 100 (e.g., when riding over rough terrain). In other embodiments, the front fork 108 and/or the rear shock absorber 136 may be integrated into the bicycle 100 in other configurations or arrangements.

Still referring to FIG. 1, the example bicycle 100 as shown may implement at least one position detection device. In the illustrated embodiment, a front position detection device 140 and a rear position detection device 142 are implemented. The front position detection device 140 is mounted in connection with the front fork 108. At least a portion of the front position detection device 140 may be integrated with the front fork 108. For example, the front position detection device 140 may include an internal portion (not shown) disposed on an interior of the front fork 108. The front position detection device 140 may further include an external portion (not shown) disposed on an exterior of the front fork 108. The front position detection device 140 may have one or more elements disposed in a front position detection housing (not shown) disposed on or integrated with the front fork 108. As described in greater detail below, the front position detection device 140 is operable to detect a position of the front fork 108.

The rear position detection device 142 as shown in FIG. 1 is mounted in connection with the rear suspension component 136. Although the rear position detection device 142 in FIG. 1 is configured to directly measure a position of the of the rear suspension component 136, it should also be appreciated that the rear position detection device 142 could be implemented to detect a position of another component, for example the swing arm 138. The rear position detection device 142 may have one or more elements integrated with the rear suspension component 136. For example, the rear position detection device 142 may include an internal portion (not shown) disposed on an interior of the rear suspension component 136. The rear position detection device 142 may further include an external portion (not shown) disposed on or integrated with the rear suspension component 136. For example, the rear position detection device 142 may have one or more elements disposed in a rear position detection housing (not shown) disposed on or integrated with the rear suspension component 136.

As described above, the front position detection device 140 and/or the rear position detection device 142 may be operable to detect positions of respective suspension components. The front position detection device 140 and the rear position detection device 142 may detect, store, and transmit data indicative of a position of respective suspension components. Position detection may occur during a suspension set up phase prior to a ride or may occur during a ride. Position information generated with the front position detection device 140 and/ the rear position detection device 142 can be reported to provide information related to suspension travel, sag, bottom out, and more. For example, position data gathered may be used to generate an average, median, or weighted average suspension position during a sampling period which may be part of or an entire ride.

Position data gathered with the front position detection device 140 and/or the rear position detection device 142 may be used for various downstream purposes related to suspension performance. For example, position data may be used to indicate service recommendations based on a total suspension cycle distance or number of cycles. Ride and/or rider characterizations may further be provided based on gathered position data. For example, widely varying position data may indicate a harsh or aggressive ride while tightly constrained position data may indicate a steady or smooth ride.

Position data may be compared between multiple position detection devices. For example, data from the front position detection device 140 may be compared with data from the rear position detection device 142 to provide position balance data. Such position balance data may be used to indicate a suspension balance, for example relative to an average or suggested suspension balance. Suspension balance data may be used to provide rider characterization, for example showing a more aggressive rider style with a wide range of travel detected by the front position detection device 140 relative to a narrow range of travel detected by the rear position detection device 142.

Position data may be reported real time to one or more other components on the bicycle and/or to another device such as a mobile device. Position data may be analyzed in real time and/or reported in a post-ride report. Real time data may be used in operations such as adjustment operations of suspension or other components. For example, position data may be analyzed and in turn result in adjustments to suspension damping control, spring control, gear changer control, adjustable seatpost control, or various other adjustable properties of bicycle components. Post-ride report position data may be used to track performance across multiple rides and/or to characterize ride data. For example, position data may be used in conjunction with GPS data and known locations such as trails to provide information about those trails. In various embodiments, position data matched with a given trail could be used to characterize trails in terms of roughness or difficulty and to suggest similar trails a rider may enjoy or wish to avoid. It should be appreciated that a rider's position data may be compiled to provide a database of a rider's own suspension performance or such data may be aggregated with other riders' position data to compare suspension performances and/or to generate average data indicative of trails which may then be reported to other riders to aid in route planning.

Further processing of position data gathered by the front position detection device 140 and/or the rear position detection device 142 may generate further rider characterizations. For example, an objective post-ride "score" may be provided to a rider to indicate various ride characteristics such as total airtime, maximum compression, average ride height, number of compressions over a certain position threshold, and more. The post-ride "score" may be used to indicate an overall level of ride technicality and provide benchmarking for the rider and social competition on various online platforms if a rider chooses.

Although FIG. 1 depicts one suspension arrangement, in other embodiments the suspension system may employ only one suspension component (e.g., only the front fork 108) or more than two suspension components (e.g., an additional suspension component on the seatpost 112) in addition to or as an alternative to the front fork 108 and rear shock absorber 136. Generally described, suspension components herein may include a first suspension element and a second suspension element movable relative to the first suspension element. A pressure chamber or other spring is provided to bias the first suspension element apart from the second suspension element, for example along a suspension axis. One of the first suspension element or the second suspension element is connected or connectable to an unsprung portion (i.e. one that is not suspended) of the bicycle 100 while the other is connected or connectable to a sprung portion of the bicycle 100 (i.e. one that is supported by suspension).

While the example bicycle 100 depicted in FIG. 1 is a type of mountain bicycle, the example front forks (and/or lower housings or housings) disclosed herein can be implemented on other types of bicycles. For example, the disclosed front forks may be used on road bicycles, as well as bicycles with mechanical (e.g., cable, hydraulic, pneumatic, etc.) and non-mechanical (e.g., wired, wireless) drive systems. The disclosed front forks can also be implemented on other types of two-wheeled, three-wheeled, and four-wheeled human powered vehicles. Further, the example front forks can be used on other types of vehicles, such as motorized vehicles (e.g., a motorcycle, a car, a truck, etc.).

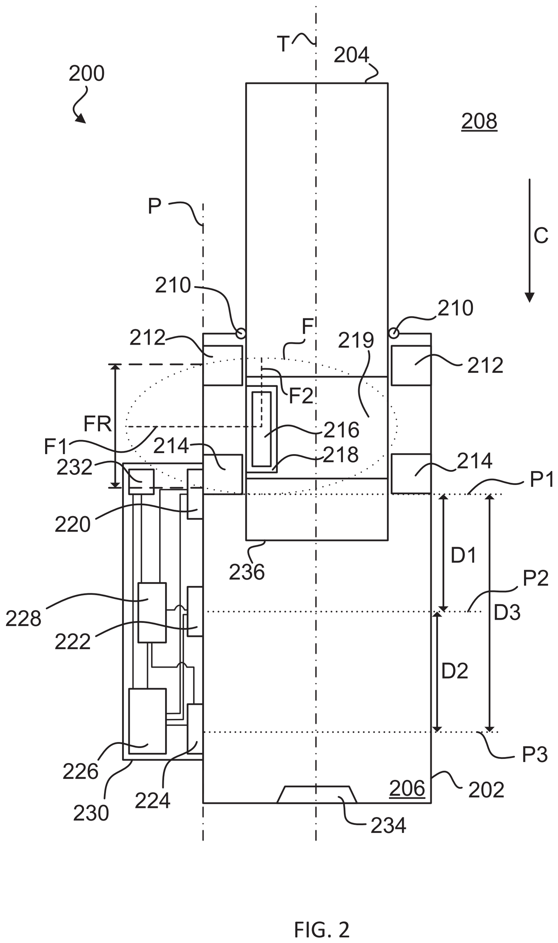

Turning now to FIG. 2, a schematic diagram of a position detection device 200 is provided. The position detection device 200 of FIG. 2 may generally be implemented as the front position detection device 140 and/or the rear position detection device 142 of FIG. 1 or as any other position detection device described elsewhere herein. Generally, the position detection device 200 includes at least one of a detectable element 216 detectable by at least a first detecting element 220 and a second detecting element 222. The first detecting element 220 and the second detecting element 222 may be used to determine location data with the detectable element 216. For example, the first detecting element 220 and the second detecting element 222 may be used to determine a position, for example a telescopic position, of a bicycle component by detecting the detectable element 216.

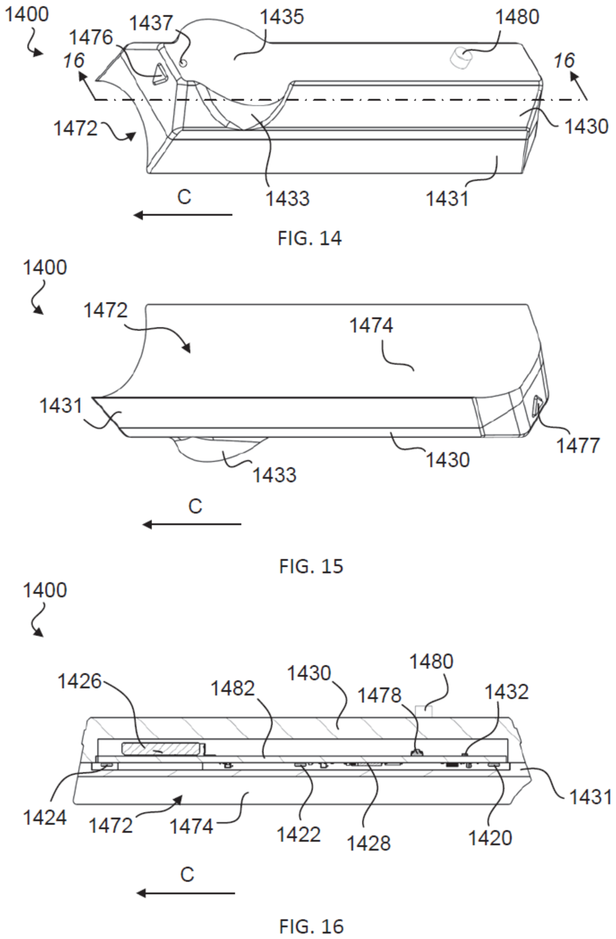

As shown in FIG. 2, a first telescopic component 202 is provided. A second telescopic component 204 is further provided and is movable along an axis T. In various embodiments, the first telescopic component 202 and the second telescopic components may be referred to as telescopic suspension components, telescopic brake components, or with suitable other modifiers. The second telescopic component 204 is movable along the axis T relative to the first telescopic component 202. The first telescopic component 202 and the second telescopic component 204 may each be configured as various components, including brake components or suspension components. As described herein, reference will be made to suspension components, but it should be appreciated that similar features and arrangements could be employed with reference to brake components, for example as described with reference to FIG. 14 below.

Still referring to FIG. 2, an interior volume 206 may be defined between the first telescopic component 202 and the second telescopic component 204. The interior volume 206 as shown is sealed from an exterior environment 208 by a sealing element 210. The sealing element 210 is shown schematically in FIG. 2 but could be provided as any dynamic seal arrangement allowing relative movement between the first telescopic component 202 and the second telescopic component 204 while maintaining a seal. For example, the sealing element 210 may include one or more of an O-ring, quad seal, labyrinth seal, or lip seal. The sealing element 210 may also include or cooperate with a lubrication feature (not shown), for example a foam element retaining a lubricant.

The embodiment of FIG. 2 further shows various alignment features. A first alignment feature 212 is provided near the sealing element 210. A second alignment feature 214 is provided spaced apart from the first alignment feature. The first alignment feature 212 and the second alignment feature 214 may be spaced apart along the axis T according to alignment needs, for example to resist relative movement between the first telescopic component 202 and the second telescopic component 204 resulting from a force component perpendicular to the axis T. The first alignment feature 212 and the second alignment feature 214 may be configured with bearing surfaces to facilitate telescopic movement between the first telescopic component 202 and the second telescopic component 204. In an embodiment, the first alignment feature 212 and the second alignment feature 214 are configured as bushings fixed to the first telescopic component 202 and slidable relative to the second telescopic component 204. One or more lubrication retention features (not shown) may be provided in the first alignment feature 212 and/or the second alignment feature 214.

Still referring to FIG. 2, a detectable element 216 is disposed in the interior volume 206. As shown, the detectable element 216 is fixed relative to the second telescopic component 204 in a detectable element housing 218. The detectable element housing 218 may be formed as a recess in the second telescopic component 204 or may be a separate element retaining the detectable element 216 in position relative to the second telescopic component 204. In various embodiments, a detectable element fixture 219 may be provided to retain the detectable element housing 218 relative to the second telescopic component 204. The detectable element 216 is arranged to travel along the axis T with the second telescopic component 204 and may be used to indicate a position of the second telescopic component 204. The detectable element 216 may be a magnet, such as an electromagnet or a permanent magnet. In other embodiments, the detectable element 216 may be a powered signal emitter such as a wireless radio.

As described above, the detectable element 216 may be a permanent magnet. For example, a singular permanent magnet embodiment of the detectable element 216 may produce a singular magnetic field. As described in greater detail below, a singular permanent magnet, or otherwise a permanent magnet with a non-repeating magnetic field may be used to consistently determine a position of the first telescopic component 202 relative to the second telescopic component 204. For example, one or more detecting elements as described in greater detail below may be configured to provide a variable output based on a relative position of the detectable element 216.

The detectable element 216 in FIG. 2 defines a field F in which it is detectable. It should be appreciated that the field F is in part determined by the detectable element 216 and in part by relevant detectors or detecting elements as described in greater detail below. The field F may represent a magnetic field, for example in the case of a permanent magnet embodiment of the detectable element 216. The field F may be tunable, for example between at least two axes. In the depicted embodiment, the field F has a first field axis F1 and a second field axis F2 orthogonal to the first field axis F1. In an embodiment, the first field axis F1 and the second field axis F2 are each representative a field magnitude and may described magnetic field lines, for example magnetic field lines of a magnitude suitable for detection. The first field axis F1 as shown is greater in magnitude than the second field axis F2. The detectable element 216 may be configured to tune a magnetic field to achieve a desired magnitude of the first field axis F1 and the second field axis F2. For example, a plurality of permanent magnets, ferromagnetic, and/or non-magnetic elements may be arranged to shape the magnetic field of the permanent magnet embodiment of the detectable element 216. It should be appreciated that other embodiments of the detectable element 216 could achieve a desired relationship between the first field axis F1 and the second field axis F2. For example, a wireless radio embodiment of the detectable element 216 may be directed to have a greater extent in the first field axis F1 than in the second field axis F2. Furthermore, in some embodiments, the second field axis F2 may have a greater magnitude than the first field axis F1. In such an embodiment, the greater magnitude aligns with the axial direction relative to the axis T.

As described above, the detectable element 216 is positionally fixed relative to the second telescopic component 204 and the second telescopic component 204 is movable within the first telescopic component 202. As the second telescopic component 204 moves along the axis T within the first telescopic component 202, one or more detectors are operable to detect the detectable element 216, for example by detecting the field F. In the embodiment of FIG. 2, a first detecting element 220 is provided with the first telescopic component 202. The first detecting element 220 is operable to wireless detect a position of the detectable element 216. For example, the first detecting element 220 may be a magnetometer, Hall effect sensor, or other sensor configured to generate an output corresponding to a magnitude of the field F of the detectable element 216. As the detectable element 216 moves relative to the first detecting element 220, the corresponding output of the first detecting element 220 changes in a predictable manner that can be continuously measured. The first detecting element 220 may thus produce an output that is indicative of a field strength of the field F and a relative position of the detectable element 216 and the first detecting element 220. As the first detecting element 220 is positionally fixed relative to the first telescopic component 202 and the detectable element 216 is positionally fixed relative to the second telescopic component 204, the output of the first detecting element 220 can be used to wirelessly indicate a relative position of the first telescopic component 202 and the second telescopic component 204. In some embodiments, such relative position may be referred to as a travel, for example in a range between minimum and maximum travel.

Still referring to FIG. 2, the first detecting element 220 and any further detecting elements may be operable to detect the detectable element 216 across one or more other components. For example, the first detecting element 220 may be configured to detect the detectable element across the second telescopic component 204. The first detecting element 220 is tunable such that an output generated by movement of the detectable element 216 on an opposite side of the second telescopic component 204 or any other components disposed therebetween is representative of a relative position of the detectable element 216 and the first detecting element 220.

The first detecting element 220 as described above is operable to detect the detectable element 216 across a range of relative positions. This range of relative positions of the detectable element 216 and the first detecting element 220 may be described with reference to a field reach R. As used herein, the field reach R is measured as a detectable range of the field F at a detecting plane P. The detecting plane P as used herein is representative of a position of the first detecting element 220 parallel to the axis T along which the first telescopic component 202 and the second telescopic component 204 travel relative to one another. The first detecting element 220 defines a first detecting axis P1 extending from the detecting plane P. The first detecting axis P1as shown is orthogonal to the detecting plane P and the axis T. However, it should be appreciated that the first detecting element 220 may be operable to perform detections along various axes. In an embodiment, the first detecting element 220 is operable to perform detections along the first detecting axis P1 and along an orthogonal first detecting axis parallel to and represented by the detecting plane P. In such an embodiment, the first detecting element 220 may generate an output based on a combination of detections made along the first detecting axis P1 and along the detecting plane P or orthogonal first detecting axis, for example as a vector indicative of an angle. As the detectable element 216 travels along the axis T relative to the first detecting element 220, resolution along one of the first detecting axis P1 or the detecting plane P may decrease (i.e. a change in detected magnitude may be small relative to a change in travel of the detectable element 216 along the axis T). In this example, the output based on a combination of detections made along the first detecting axis P1 and the detecting plane P can ensure that an output indicative of an accurate travel position of the detectable element 216 along the axis T is generated. Although described herein as generally orthogonal and parallel to the travel axis T, it should be appreciated that detections may be performed along any axis at any relative angle to the travel axis T or to other detections performed.

The first detecting element 220 may be used as described above to wirelessly detect positions of the detectable element 216. For example, the first detecting element 220 as shown in FIG. 2 is operable to detect positions of the detectable element 216 corresponding to an overlap range of the field reach FR relative to the first detecting axis P1. Although outputs may still be generated by the first detecting element 220 responsive to positions of the detectable element 216 outside of this overlap range of the field reach FR, resolution may be reduced. It should be appreciated that magnitude and shape of the field F and detecting power of the first detecting element 220 are tunable features and may be adjusted to achieve desired ranges and resolutions. However, as described below, further detecting elements may also be provided.

Still referring to FIG. 2, the first detecting element 220 may be tunable to detect the detectable element 216. For example, the detectable element 216 may in some embodiments provide a peak magnetic field strength of +/- 5, 10, 15, or 20 millitesla (mT). Accordingly, the first detecting element 220 and any additional detecting element(s) may be tuned with a sensitivity range of +/- 5mT, +/- 25mT, or +/- 50mT.

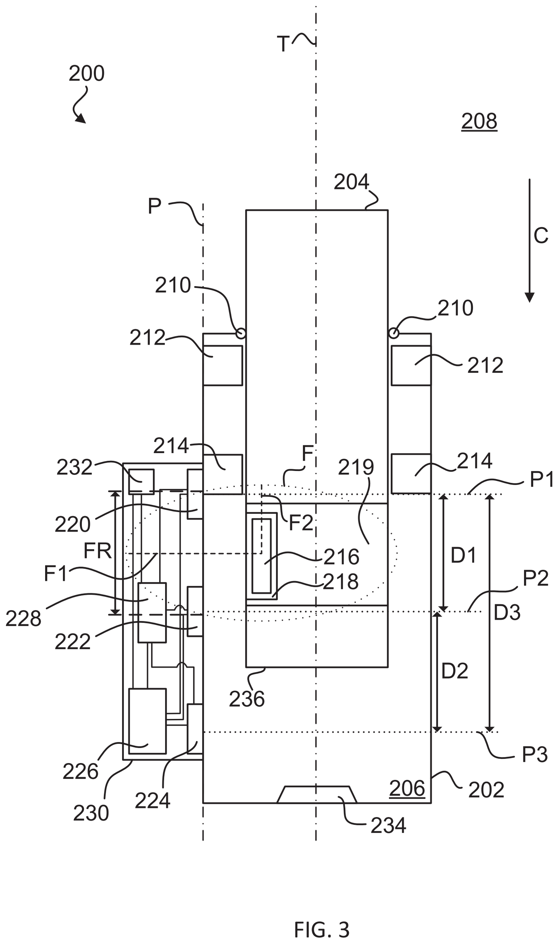

Turning now to FIG. 3, a schematic view of the position detection device 200 of FIG. 2 is shown in a second position. The second position depicted in FIG. 3 represents a compression movement of the first telescopic component 202 relative to the second telescopic component 204 from the first position shown in FIG. 2. As the second telescopic component 204 moves along the travel axis T in a compression direction C, the detectable element 216 similarly moves relative to the first detecting element 220. As shown in FIG. 3, while the field reach FR of the detectable element 216 is overlapping the first detecting axis P1 of the first detecting element 220, the field reach FR of the detectable element 216 is also overlapping a second detecting axis of a second detecting element 222. The second detecting element 222 is spaced apart from the first detecting element 220. As depicted, the second detecting element 222 is spaced apart from the first detecting element 220 by a first distance D1 along the detecting plane P. In the present embodiment, the first distance D1 is tuned to provide increased range over a single detecting element while ensuring that at least one detecting element is always operable to generate an output indicative of position of the detectable element 216 based on sensor data. In an embodiment, the first distance D1 is less than the field reach FR. In such an embodiment, an effective travel measurement range could be represented by the first distance D1 plus twice the field reach FR, since the detectable element 216 is detectable by at least one of the first detecting element 220 or the second detecting element 222 throughout this range.

It should be appreciated that the field reach FR is a tunable feature to achieve various goals. For example, the field reach FR may be tuned by increasing a field strength, for instance by providing a stronger permanent magnet. The field reach FR may also be tuned by tuning a field strength, for instance by arranging permanent magnets to increase the first field axis F1 and decrease the second field axis F2. The field reach FR may also be tuned by adjusting a detecting power of one or more detecting elements such as the first detecting element 220. In an example, the field reach FR is tuned such that the detectable element 216 is detectable by each of the first detecting element 220 and the second detecting element 222 in at least one travel position. As above, the first distance D1 may be tuned according to the field reach FR, for example being less than or equal to the field reach FR. In various examples, the first distance D1 is at least twenty millimeters (20mm), thirty millimeters (30mm), forty millimeters (40mm), fifty millimeters (50mm), sixty millimeters (60mm), seventy millimeters (70mm), or eighty millimeters (80mm).

In the depicted embodiment, the first detecting element 220 may be tuned to detect a position or range of positions of the detectable element 216 and the second detecting element 222 may be tuned to detect a position or range of positions of the detectable element 216. As shown in FIG. 2, the first detecting element 220 may be tuned to detect this depicted first position of the detectable element 216. The second detecting element 222 may be tuned to detect the second position of the detectable element 216 depicted in FIG. 3. As described above, the first detecting element 220 may have a range of detection fidelity. For example, the first detecting element 220 may have a continuous range of detection fidelity defined by its overlap with the field reach FR. In another example, the first detecting element 220 may have a discontinuous range, for example defined by its overlap with the field reach FR but excluding a central range where the first field axis F1 overlaps the first detecting element 220. In this example, outputs from the first detecting element 220 may be supplemented or superseded by another detecting element such as the second detecting element 222. As shown in FIG. 3, the first detecting element 220 and the second detecting element 222 may, at some positions of the detectable element 216, have identical or similar overlaps with the field reach FR. In this example, comparisons against expected values can be used to choose which output to use for position determination. For example, a first lookup table may be used to compare expected output values from the first detecting element 220 and a second lookup table may be used to compare expected output values from the second detecting element 222. It should be appreciated that, based on these comparisons, data from either one or both of the first detecting element 220 and the second detecting element 222 may be used for a positional determination of the detectable element 216.

Still referring to FIG. 3, the depicted position of the second telescopic component 204 relative to the first telescopic component 202 may also be referred to as an intermediate position. As shown in FIG. 3, the detectable element 216 is disposed between the first detecting element 220 and the second detecting element 222 along the axis T and along the detecting plane P. In this intermediate position, the detectable element 216 is detectable by each of the first detecting element 220 and the second detecting element 222. For example, the first detecting element 220 and the second detecting element 222 may be tuned to detect this intermediate position of the detectable element 216.

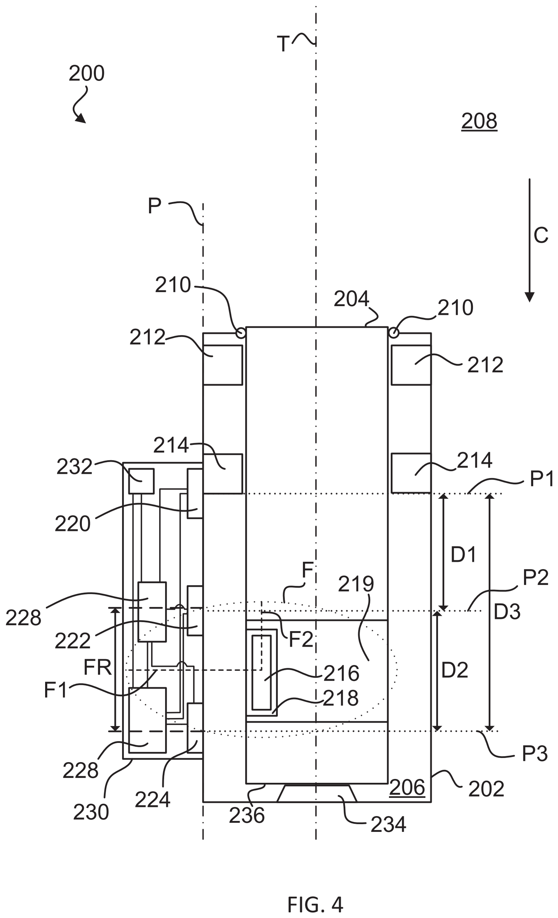

Turning now to FIG. 4, a schematic view of the position detection device 200 of FIGS. 2 and 3 is shown in a third position. As shown in FIG. 4, the field reach FR overlaps with a third detecting axis P3 of a third detecting element 224. As shown in FIG. 4, the third detecting element 224 is spaced apart from the second detecting element 222 by a second distance D2 along the detecting plane P. In the present embodiment, the second distance D2 is tuned to provide increased range over a combination of only the first detecting element 220 and the second detecting element 222 while ensuring that at least one detecting element is always operable to generate an output indicative of position of the detectable element 216 based on sensor data. In an embodiment, the second distance D2 is less than the field reach FR. As shown, the second distance D2 may be similar or equal to the first distance D1 as described above. In such an embodiment, an effective travel measurement range could be represented by the first distance D1, plus the second distance D2, plus twice the field reach FR, since the detectable element 216 is detectable by at least one of the first detecting element 220, the second detecting element 222, or the third detecting element 224 throughout this range.

Still referring to FIG. 4, a third distance D3 is defined between the first detecting axis P1 of the first detecting element 220 and the third detecting axis P3 of the third detecting element 224. The third distance D3 may be used to define a total detecting range. For example, the total detecting range may be defined as the third distance D3 plus twice the field reach FR, since the detectable element 216 is detectable by at least one of the first detecting element 216, the second detecting element 222, or the third detecting element 224 throughout this range. As described above, the third distance D3 is inclusive of the first distance D1 and the second distance D2. In an example, the third distance D3 may be equal to double the first distance D1 or double the second distance D2. However, the third distance D3 may be greater than double the first distance D1 or greater than double the second distance D1, for example where the first distance D1 and the second distance D2 are not equal.

As shown in the third position depicted in FIG. 4, one or more features may be provided to control travel of the second telescopic component 204 relative to the first telescopic component 202. For example, a first travel stop 234 may be provided with the first telescopic component 202 and a second travel stop 236 may be provided with the second telescopic component 204. In the example of FIG. 4, the first travel stop 234 is configured to physically interface with the second travel stop 236. The first travel stop 234 may be configured as a spring, for example an elastomeric element, such that a stop range is controlled. The second travel stop 234 may be a face or other feature provided with the second telescopic component 204 and may be elastomeric or substantially incompressible. In an example, an elastomeric embodiment of the first travel stop 234 provides an increasing resistance to travel of the second telescopic component 204 as the second telescopic component 204 travels in the compression direction C. Interaction between the first travel stop 234 and the second travel stop 236 may accordingly be used to damp a compression or bottom out force between the first telescopic component 202 and the second telescopic component 204, for example in a suspension embodiment of the schematic example of FIGS. 2-4.

As described above with reference to FIG. 3, the first distance D1 may be at least 20mm, 30mm, 40mm, 50mm, 60mm, 70mm or 80mm. It should be appreciated that various other magnitudes of the first distance D1 are contemplated. For example, a braking embodiment of the schematic in FIGS. 2-4 may have a first distance in the range of two millimeters (2mm) to ten millimeters (10mm). In a suspension embodiment of the schematic of FIGS. 2-4, the second distance may be at least 20mm, 30mm, 40mm, 50mm, 60mm, 70mm or 80mm. In this example, the third distance D3 may thus be at least double these values. Based on the ranges described above, including double the field reach FR, total detectable ranges may be described. In an embodiment only including the first detecting element 220, a range of double the field reach FR may be detectable. A magnitude of that range of the first detecting element 220 may be at least forty millimeters (40mm), sixty millimeters (60mm), eighty millimeters (80mm), one hundred millimeters (100mm), one hundred twenty millimeters (120mm), one hundred forty millimeters (140 mm), or one hundred sixty millimeters (160 mm). Inclusion of further detecting elements can be used to increase the detecting range. For example, inclusion of the second detecting element 222 with the first detecting element 220 may increase such range by a magnitude of the first distance D1. Inclusion of the third detecting element 224 with the first detecting element 220 and the second detecting element 222 may increase the magnitude of that range by a magnitude of the second distance D2.

Referring again to FIG. 4, a communication interface 232 is provided in communication with the first detecting element 220. The communication interface 232 is operable to transmit a signal responsive to detections made by the first detecting element 220. In the depicted example, the communication interface 232 is provided in communication with the first detecting element 220, the second detecting element 222, and the third detecting element 224. The communication interface 232 and the first detecting element 220 or further detecting elements may be in direct communication or may have one or more further features in communication between. For example, as shown in FIG. 4, the first detecting element 220, the second detecting element 222, and the third detecting element 224 may each communicate with a processor 228. The processor 228 is configured to process outputs from the detecting elements 220, 222, 224. The processor 228 in this example is further configured to communicate an output to the communication interface 232. The output of the processor 228 may represent various outputs of the detecting elements 220, 222, 224. For example, the processor 228 may produce an output indicative of a position of the detectable element 216 based on an output of at least one of the detecting elements 220, 222, 224.

The processor 228 may also communicate outputs to the detecting elements 220, 222, 224. For example, the processor 228 may communicate an output to at least one of the detecting elements 220, 222, 224 to adjust a detecting quality and/or power. In an embodiment, the processor 228 communicates an output to at least one of the detecting elements 220, 222, 224 to increase a detecting power based on a detected noise level or a flagged output from the at least one of the detecting elements 220, 222, 224.

The processor 228 may be variously configured to communicate between at least one of the detecting elements 220, 222, 224 and the communication interface 232. In some examples, the communication interface 232 may be integrated with the processor 228, for example on the same printed circuit board. For example, the processor 228 may be a system on chip processor. The processor 228 and communication interface 232 may thus be configured to process outputs from at least one of the detecting elements 220, 222, 224 and transmit an output to another device such as a portable device, head unit, or another bicycle component. In various embodiments, the processor 228 may be one of an nRF family processor from Nordic Semiconductor^{®}. For example, the processor 228 may be one of an nRF52833, nRF52840, or nRF54L15 from Nordic Semiconductor^{®}.

The communication interface 232 may be wired or wireless. As described above, the communication interface 232 may be wired to the processor 228 or otherwise integrated with the processor 228. The communication interface 232 may also be wired to at least one of the detecting elements 220, 222, 224. The communication interface 232 may additionally or alternatively include a wireless radio. For example, the communication interface 232 may include at least one of a Bluetooth^{®}, mesh, Thread, LoRa, NFC, ANT, 802.15.4, 2.4 GHz, or Zigbee-capable radio for transmitting and/or receiving signals. It should be appreciated that the communication interface 232 and/or the processor 228 can be configured to transmit encrypted signals, and may employ a count value or rolling code to further secure communications.

Still referring to FIG. 4, a power source 226 is provided in communication with at least one of the detecting elements 220, 222, 224. As shown, the power source 226 is in communication with and provides electrical power to the processor 228, the communication interface 232, the first detecting element 220, the second detecting element 222, and the third detecting element 224. The power source 226 may be replaceable and/or rechargeable. In an example, the power source 226 is at least one button or coin cell battery. For example, the power source 226 may be a CR1620, CR 1632, CR2032, CR1025, or CR2477 button cell battery. The power source 226 may be removable, for example toollessly removable. As shown in FIG. 4, the power source 226 may be housed in one or more structures. For example, the depicted embodiment provides a detecting housing 230 that houses the power source 226. The detecting housing 230 of the present example houses the processor 228, the communication interface 232, the first detecting element 220, the second detecting element 222, and the third detecting element 224.

As described above, one or more electrical components may be disposed in the detecting housing 230. For example, the power source 226 may be removably or non-removably disposed in the detecting housing 230. The power source 226 may also be disposed outside of the detecting housing 230. For example, the power source 226 may be removably attached to an outside of the detecting housing 230.

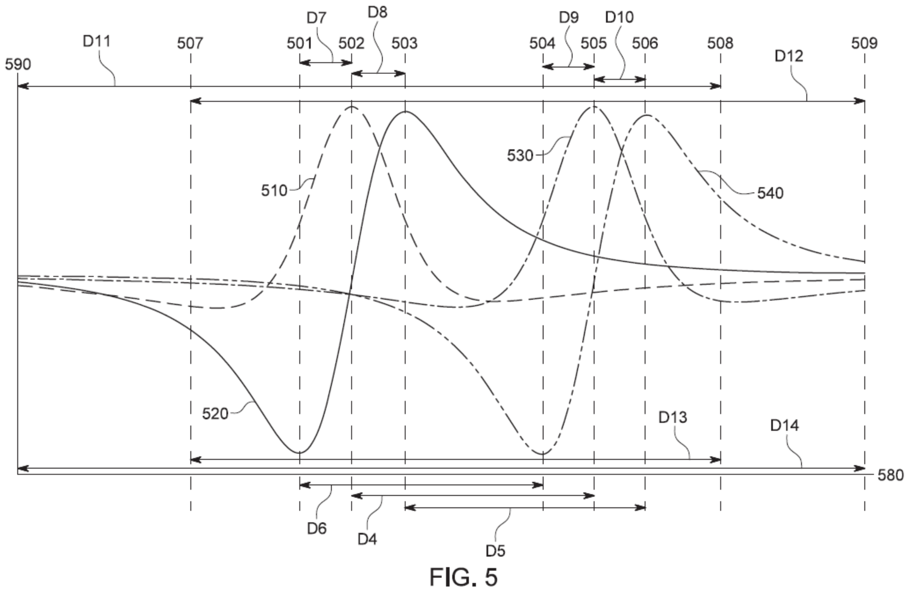

Turning now to FIG. 5, a graph illustrating outputs of the position detection device 200 shown in FIGS. 2-4 is shown. The graph of FIG. 5 depicts various traces measured along an x-axis 580 and a y-axis 590. The x-axis 580 is representative of a travel position of the second telescopic component 204 relative to the first telescopic component 202. For example, the x-axis 580 may be a linear scale denominated in millimeters. The y-axis 590 is representative of detector output, for example outputs from the first detecting element 220 and the second detecting element 222 as described with reference to FIGS. 2-4 above. The y-axis may thus be representative of a magnetometer reading, for example denominated in mT.

In the graph of FIG. 5, a first trace 510, a second trace 520, a third trace 530, and a fourth trace 540 are shown. The first trace 510 is representative of a first output from a first detecting element and the second trace 520 is a representative of a second output from the first detecting element. The first detecting element described with reference to FIG. 5 may be any detecting element and will be described using the example of the first detecting element 220 described with reference to FIGS. 2-4 above. As shown in the graph of FIG. 5, the first trace 510 describes a first trace maximum output 502, which may be an absolute maximum output or a local maximum output. In the example of a magnetometer described with reference to FIGS. 2-4 above, the first trace maximum output 502 of FIG. 5 represents a maximum magnetometer reading.

Still referring to FIG. 5, the second trace 520 describes a second trace maximum output 503, which may be an absolute maximum output or a local maximum output. Using the example of FIGS. 2-4 described above, the second trace maximum output 503 represents a maximum magnetometer reading. The first trace maximum output 502 and the second trace maximum output 503 may represent distinct maximum outputs of the same magnetometer. For example, a multi-axis magnetometer may be employed, wherein the first trace 510 is representative of an output of a first axis of the multi-axis magnetometer and the second trace 520 is representative of an output of a second axis of the multi-axis magnetometer. The first axis and the second axis may have any angular relationship but will be described in this example as having an orthogonal, specifically perpendicular, relationship. For example, the first trace 510 may be representative of an axial magnetometer reading (i.e. parallel to the detecting plane P of FIGS. 2-4) and the second trace 520 may be representative of a radial magnetometer reading (i.e. perpendicular to the detecting plane P, for example along the first detecting axis P1 in FIGS. 2-4).

The second trace 520 of FIG. 5 further describes a second trace minimum output 501. Continuing with the multi-axis magnetometer example described above, the second trace minimum output 501 is representative of a local or absolute minimum of the radial magnetometer reading of the first detecting element 220 as described with reference to FIGS. 2-4. Accordingly, the second trace 520 describes both a second trace minimum output 501 and a second trace maximum output 503. As can be seen in the graph of FIG. 5, the second trace 520 can be described as having a first peak output corresponding to the second trace minimum output 501 and a second peak output corresponding to the second trace maximum output 503 while the first trace 510 can be described as having a single peak output corresponding to the first trace maximum output 502. As described above, the peak outputs of the second trace 520 in the example of an axial magnetometer reading represent peak magnetometer outputs measured parallel to the detecting plane P of FIGS. 2-4 while the peak output of the first trace 510 in the example of a radial magnetometer represents a peak magnetometer output measured along the first detecting axis P1 of FIGS. 2-4.

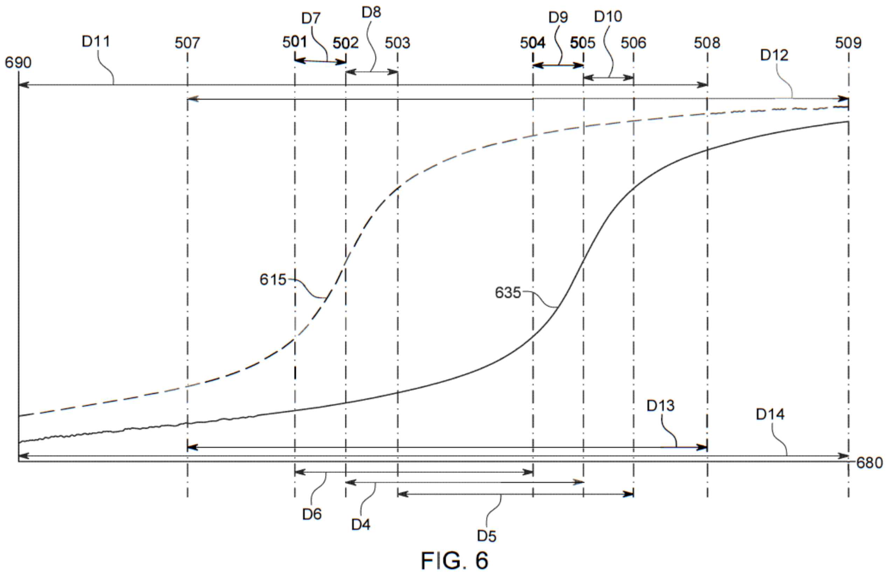

In FIG. 5, a first peak to peak distance D7 is measured between the second trace minimum output 501 and the first trace maximum output 502. A second peak to peak distance D8 is measured between the first trace maximum output 502 and the second trace maximum output 503. Together, the combination of the first peak to peak distance D7 and the second peak to peak distance D8 may be referred to as a first magnetometer central zone. Throughout this combination of the first peak to peak distance D7 and the second peak to peak distance D8, the combination of the axial and radial components of a first magnetometer cooperate to provide reliable data based on a relatively strong magnetic field reading. Near each of the peaks, a high rate of change along the y-axis 590 exists for a given amount of travel along the x-axis 580. As will be described in greater detail with reference to FIG. 6 below, the first trace 510 and the second trace 520 may be combined, for example to represent an angle, to provide a relatively consistent rate of change along the y-axis 590 throughout the first peak to peak distance D7 and the second peak to peak distance D8. Accordingly, the first peak to peak distance D7 and the second peak to peak distance D8 may represent an area of high fidelity magnetometer readings of a first magnetometer such as the first detecting element 220 described with reference to FIGS. 2-4 above.

Still referring to FIG. 5, the third trace 530 and the fourth trace 540 may together describe axial and radial magnetometer readings, for example as described with reference to the second detecting element 222 in FIGS. 2-4 above. As shown in the graph of FIG. 5, the third trace 520 describes a third trace maximum output 505, which may be an absolute maximum output or a local maximum output. In the example of a magnetometer described with reference to FIGS. 2-4 above, the third trace maximum output 505 of FIG. 5 represents a maximum magnetometer reading. The fourth trace 540 describes a fourth trace maximum output 506, which may be an absolute maximum output or a local maximum output. Using the example of FIGS. 2-4 described above, the fourth trace maximum output 506 represents a maximum magnetometer reading. The third trace maximum output 505 and the fourth trace maximum output 506 may represent distinct maximum outputs of the same magnetometer. For example, a multi-axis magnetometer may be employed, wherein the third trace 530 is representative of an output of a first axis of the multi-axis magnetometer and the fourth trace 540 is representative of an output of a second axis of the multi-axis magnetometer. The first axis and the second axis may have any angular relationship but will be described in this example as having an orthogonal, specifically perpendicular, relationship. For example, the third trace 530 may be representative of an axial magnetometer reading (i.e. parallel to the detecting plane P of FIGS. 2-4) and the fourth trace 540 may be representative of a radial magnetometer reading (i.e. perpendicular to the detecting plane P, for example along the second detecting axis P2 in FIGS. 2-4).

The fourth trace 540 of FIG. 5 further describes a fourth trace minimum output 504. Continuing with the multi-axis magnetometer example described above, the fourth trace minimum output 504 is representative of a local or absolute minimum of the radial magnetometer reading of the second detecting element 222 as described with reference to FIGS. 2-4. Accordingly, the fourth trace 540 describes both a fourth trace minimum output 504 and a fourth trace maximum output 506. As can be seen in the graph of FIG. 5, the fourth trace 540 can be described as having a first peak output corresponding to the fourth trace minimum output 504 and a second peak output corresponding to the fourth trace maximum output 506 while the third trace 530 can be described as having a single peak output corresponding to the third trace maximum output 505. As described above, the peak outputs of the fourth trace 540 in the example of an axial magnetometer reading represent peak magnetometer outputs measured parallel to the detecting plane P of FIGS. 2-4 while the peak output of the third trace 530 in the example of a radial magnetometer represents a peak magnetometer output measured along the second detecting axis P2 of FIGS. 2-4.

In FIG. 5, a third peak to peak distance D9 is measured between the fourth trace minimum output 504 and the third trace maximum output 505. A fourth peak to peak distance D 10 is measured between the third trace maximum output 505 and the fourth trace maximum output 506. Together, the combination of the third peak to peak distance D9 and the fourth peak to peak distance D10 may be referred to as a second magnetometer central zone. Throughout this combination of the third peak to peak distance D9 and the fourth peak to peak distance D 10, the combination of the axial and radial components of a second magnetometer cooperate to provide reliable data based on a relatively strong magnetic field reading. Near each of the peaks, a high rate of change along the y-axis 590 exists for a given amount of travel along the x-axis 580. As will be described in greater detail with reference to FIG. 6 below, the third trace 530 and the fourth trace 540 may be combined, for example to represent an angle, to provide a relatively consistent rate of change along the y-axis 590 throughout the third peak to peak distance D9 and the fourth peak to peak distance D10. Accordingly, the third peak to peak distance D9 and the fourth peak to peak distance D10 may together represent an area of high fidelity magnetometer readings of a second magnetometer such as the second detecting element 222 described with reference to FIGS. 2-4 above.

Still referring to FIG. 5, the first magnetometer central zone defined by the first peak to peak distance D7 and the second peak to peak distance D8 may be spaced apart from the second magnetometer central zone defined by the third peak to peak distance D9 and the fourth peak to peak distance D10. This spacing apart may be representative of a spacing apart of first and second magnetometers, for example in the case of the first detecting element 220 and the second detecting element 222 as described with reference to FIGS. 2-4 above. In this regard, a first spacing D4 may be defined between the first trace maximum output 502 and the third trace maximum output 505. A second spacing D5 may be defined between the between the second trace maximum output 503 and the fourth trace maximum output 506. A third spacing D6 may be defined between the second trace minimum output 501 and the fourth trace minimum output 504. Each of the first spacing D4, the second spacing D5, and the third spacing D6 may be equal in magnitude, for example in the case of equal magnitudes of the first peak to peak distance D7, the second peak to peak distance D8, the third peak to peak distance D9, and the fourth peak to peak distance D10. It should also be appreciated that these relative distances may be tuned based on sensor placement and/or sensitivity.

Together, the first spacing D4, the second spacing D5, and the third spacing D6 define a magnetometer overlap zone, for example where outputs of first and second magnetometers may be used conjunctively. Specifically, a zone defined between the second trace maximum output 503 and the fourth trace minimum output 504 may be used to define a distance between nearest peak outputs of respective magnetometers, which may be spaced apart as shown or may overlap. In an example, this distance between nearest peak outputs may be tuned to maximize distance between respective magnetometers while ensuring reliable position data throughout this range.

In the example of FIG. 5, a total range of travel along the x-axis 580 is represented between the origin at the y-axis 590 and a maximum travel 509. Within this range, respective magnetometers may have defined useful ranges. For example, magnetometer data may be particularly useful within a range near its peaks. As shown, first magnetometer data represented by the first trace 510 and the second trace 520 may define a first magnetometer range D11 between the origin at the y-axis 590 and a first magnetometer transition 508. The first magnetometer transition 508 does not necessarily represent a point at which first magnetometer readings are no longer used or preferred but instead may represent a point beyond which only second magnetometer readings are used. Second magnetometer data represented by the third trace 530 and the fourth trace 540 may define a second magnetometer range D12 between a second magnetometer transition 507 and the maximum travel 509. The second magnetometer transition 507 does not necessarily represent a point at which second magnetometer readings are no longer used or preferred but instead may represent a point beyond which only first magnetometer readings are used. It should be appreciated that the described ranges are tunable and could overlap to any desired degree.

An overlap range D13 is defined in FIG. 5 between the second magnetometer transition 507 and the first magnetometer transition 508. The overlap range D13 is indicative of a range where each of the first and second magnetometers, for example the first detecting element 220 and the second detecting element 222 in FIGS. 2-4, provide useful position data. It should be appreciated that an example may be tuned so that all travel is achieved in the overlap range D13, or that as shown in FIG. 5, useful readings are facilitated beyond this overlap range D13 by using data from first and second magnetometers individually.

Turning now to FIG. 6, another graph illustrating outputs of the position detection device shown in FIGS. 2-4 is shown. Description of the graph of FIG. 6 will continue with the above example of the graph shown in FIG. 5. Specifically, the same reference to the embodiments of FIGS. 2-4 may be made using the same magnitudes along the shown axes. However, it should be appreciated that the graph of FIG. 6 could represent various values and magnitudes representative of other examples contemplated herein. The graph of FIG. 6 includes an x-axis 680 representative of a travel position of the second telescopic component 204 relative to the first telescopic component 202 and a y-axis 690 representative of a detector output.

In FIG. 6, a fifth trace 615 and a sixth trace 635 are shown. The fifth trace 615 is representative of first magnetometer data and the sixth trace 635 is representative of second magnetometer data. For example, the fifth trace 615 may describe a relationship between the first trace 510 and the second trace 520 of FIG. 5, for example an angular relationship. With reference to the multi-axis magnetometer example described above, the fifth trace 615 represents a calculated angle based on orthogonal components, for example axial and radial components. The sixth trace 635 of FIG. 6 in this example may describe a relationship between the third trace 530 and the fourth trace as shown in in FIG. 5, for example an angular relationship. Again with reference to the multi-axis magnetometer example described above, the sixth trace 635 represents a calculated angle based on orthogonal components, for example axial and radial components.

As can be seen in FIG. 6, the fifth trace 615 may provide smooth and reliable position data at least between the origin at the y-axis 690 and the first magnetometer transition 508. Between the first magnetometer transition 508 and the maximum travel 509, the fifth trace 615 may provide relatively unpredictable position data. In this example, data from the sixth trace 635 provides smooth and reliable position data over this range. The sixth trace 635 may provide smooth and reliable data at least between the second magnetometer transition 507 and the maximum travel 509. Between the origin at the y-axis 690 and the second magnetometer transition 507, the sixth trace 635 may provide relatively unpredictable position data. As described above, the fifth race 615 provides smooth and reliable position data over this range. Accordingly, smooth and reliable position data is ensured over the entire range from the origin at the y-axis 690 to the maximum travel 509.

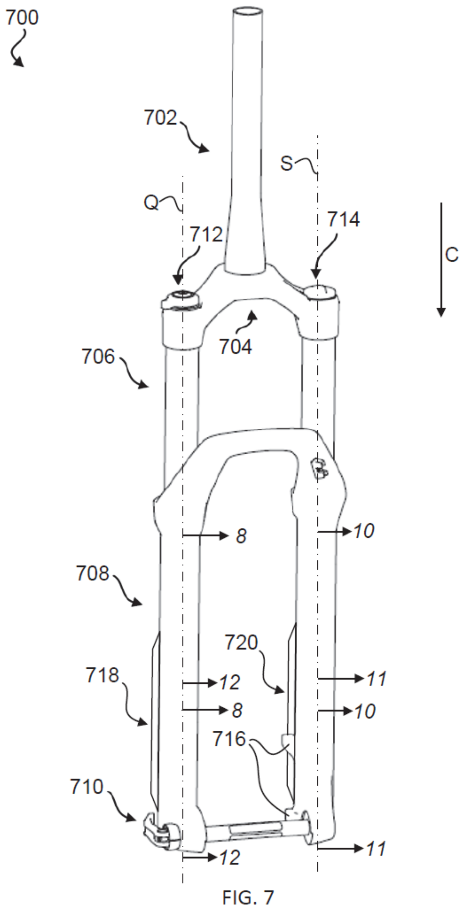

Turning now to FIG. 7, a perspective view of a front fork 700 is provided. The front fork 700 may be used to employ a position detection device as described elsewhere herein, for example the position detection device 200 as described with reference to FIGS. 2-4. The front fork 700 as shown in FIG. 7 generally includes a steerer 702 for attaching to a frame of a bicycle (for example the frame 102 of FIG. 1). The steerer 702 connects with a crown assembly 704. The crown assembly 704 transmit forces between further suspension components to the steerer. For example, the crown assembly 704 transmits steering torque from a rider input through to a wheel (i.e. the front wheel 104 of FIG. 1) connected at a wheel mounting portion 710 and transmits suspension forces through the steerer 702 to the rider. An upper assembly 706 is connected to the crown assembly 704. The upper assembly 706 may comprise one or more upper tubes, for example the two upper tube configuration provided in FIG. 7. In other examples, a single tube configuration may be provided. It should also be appreciated that while the upper assembly 706 and the crown assembly 704 are shown as separate components, they may be at least in part integrally formed. For example, an inverted or upside-down configuration of a fork may have a unitary crown and upper assembly (not shown). A lower assembly 708 is movable relative to the upper assembly 706. Each of the lower assembly 708 and the upper assembly 706 may be independently referred to as suspension elements. The relative movement of the lower assembly 708 and the upper assembly 706 is used to provide suspensioning of the front fork 700. This relative movement of the lower assembly 708 and the upper assembly 706 may be along an axis with a tube-in-tube configuration as shown in FIG. 7, or may follow a different path, for example with various linkages controlling movement. Although the example in FIG. 7 depicts the upper assembly 706 being received within the lower assembly 708, it should also be appreciated that the lower assembly 708 could be received within the upper assembly 706 as in the case with inverted forks.

Still referring to FIG. 7, The front fork 700 further includes a damper portion 712 and a spring portion 714. The spring portion 714 may be an air, metallic coil, or other spring configuration and is configured to support a rider weight. The damper portion 712 is configured to control movement of the spring portion 714 and may be tunable in various aspects. Although the damper portion 712 and the spring portion 714 are shown in distinct legs of the front fork 700, it should be appreciated that the damper portion 712 and the spring portion 714 may also be combined in the same leg of the front fork 700, either in a single leg or in both legs. A brake mounting portion 716 is also provided for accommodating a brake, such as a mechanical or hydraulic brake caliper (not shown) for acting on a brake rotor (not shown). The brake mounting portion 716 may be provided on a single leg as shown, on the side of the damper portion 712 or the spring portion 714. A second brake mounting portion (not shown) may also be provided on an opposite leg of the front fork 700.

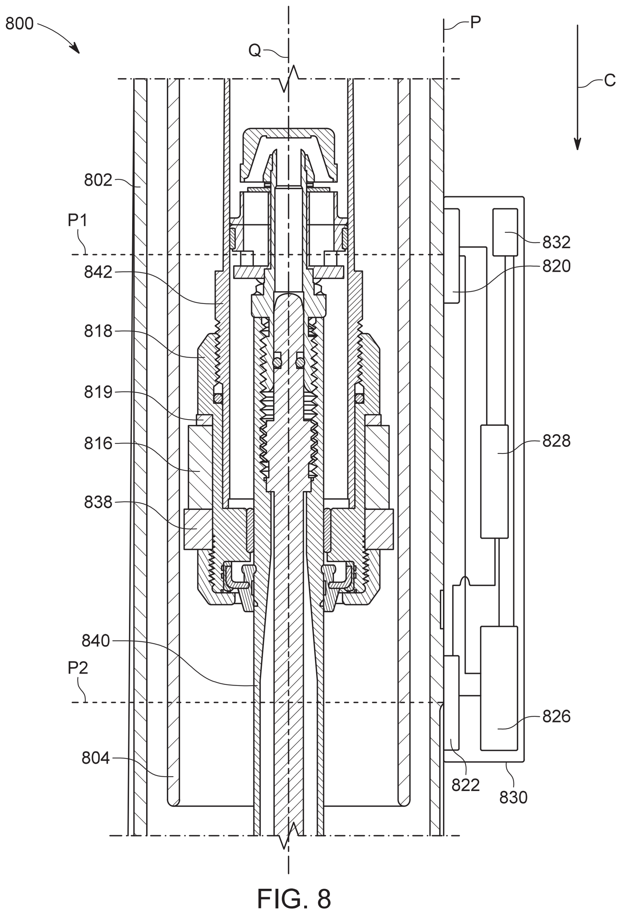

FIG. 7 further depicts a first position detection housing 718 and a second position detection housing 720. The position detection housings 718, 720 may be configured as in other examples described herein, for example those with reference to FIGS. 2-4 and the position detection device 200. The cut lines 8-8, *10-10,* 11-11, and *12-12* shown in FIG. 7 schematically depicts a portion of the front fork from which various embodiments in FIGS. 8-13 will be described now.

Turning now to FIG. 8, a first example of a sectional view of a position detection device 800 taken along the cut line 8-8 from the schematic view in FIG. 7 is provided. The position detection device 800 as described with reference to FIG. 8 includes a first leg 802 and a second leg 804. As shown, the first leg 802 may be a lower leg, for example part of the lower assembly 708 described with reference to FIG. 7. The second leg 804 may be an upper leg, for example part of the upper assembly 706 described with reference to FIG. 7. The portion depicted in FIG. 8 may generally be referred to as an overlap region wherein the first leg 802 and the second leg overlap axially relative to a damper axis Q. The first leg 802 and the second leg 804 in the example of FIG. 8 are each of a generally tubular configuration. The first leg 802, also referred to as a first tube, defines a first leg volume or a first tube volume. The second leg 804, also referred to as a second tube, defines a second leg volume or a second tube volume. As shown, the second leg 804 is disposed at least in part within the volume defined by the first leg 802. As described above with reference to the first telescopic component 202 and the second telescopic component 204 of FIGS. 2-4, the second leg 804 is configured to telescopically translate relative to the first leg 802. For example, as shown in FIG. 8, the second leg 804 may translate along the damper axis Q relative to the first leg 802. The damper axis Q may generally describe an axis of translation, for example as described with reference to the axis T described in reference with FIGS. 2-4.

Still referring to FIG. 8, a detectable element 816 is provided. As described elsewhere herein, the detectable element 816 may be of various configurations including a permanent magnet configuration generating a magnetic field. The detectable element 816 may also be referred to as a field generating element. The detectable element 816 may be disposed at least in part in the volume defined by the first leg 802. For example, the detectable element 816 as shown in FIG. 8 is disposed in the volume defined by the first leg 802 and in the volume defined by the second leg 804.

The detectable element 816 may be fixed relative to the second leg 804 with various configurations. For example, the detectable element 816 as shown in FIG. 8 is provided in a detectable element housing 818 and is fixed at least by a detectable element fixture 819. The detectable element fixture 819 may be an elastomeric element, a circlip, an adhesive, or various other fixing means. As depicted in the present example, a detectable element limiter 838 may also in part retain the detectable element 816 relative to the second leg 804. The detectable element limiter 838 may be an elastomeric element or a relatively rigid element and may be further configured to provide alignment. For example, the detectable element limiter 838 as shown may radially limit movement of the second leg 804 relative to the detectable element housing 818.

As shown in FIG. 8, the detectable element 816 may further be fixed relative to a body 842. The body 842 may also be referred to as a damper body, at least in part controlling a damping fluid. The body 842 is fixed relative to the second leg 804 and is accordingly movable with the second leg 804 along the damper axis Q. A rod 840 is movable at least in part within the body 842. For example, the rod 840 may be movable through damping fluid within the body 842 to control relative movement of the first leg 802 and the second leg 804. The rod 840 is fixed relative to the first leg 802.

At least one detector may be provided for detecting a magnetic field of the detectable element 816. For example, as shown in FIG. 8, a first detecting element 820 and a second detecting element 822 are provided. The first detecting element 820 and the second detecting element 822 may be disposed external to the volume defined by the first leg 802 and the volume defined by the second leg 804. For example, the first detecting element 820 and the second detecting element 822 as shown are disposed in a detecting housing 830. The detecting housing as shown is disposed on an external face of the first leg 802. It is also contemplated that the detecting housing could be integrated into the first leg 802, for example in a detecting housing cavity (not shown) of the first leg 802. As shown in FIG. 8, the first detecting element 820 and the second detecting element 822 may generally be described as disposed in an exterior while the detectable element may generally be described as being disposed in an interior.

Still referring to the example of FIG. 8, the first detecting element 820 and/or the second detecting element 822 are shown on an opposite side of one or more elements from the detectable element 816. For example, the first detecting element 820 and the second detecting element 822 may each be described as on an opposite side of the first leg 802 from the detectable element 816. The first detecting element 820 and the second detecting element 822 may also each be described as on an opposite side of the second leg 804 from the detectable element 816. It should be appreciated that the first detecting element 820 and/or the second detecting element 822 may be provided in a distinct detecting housing 830 or integrated with one or more elements and still detect the detectable element 816 across one or more elements. For example, the first detecting element 820 and/or the second detecting element 820 may housed integrally with the first leg 802 and be operable to detect a position of the detectable element 816 across the second leg 804.

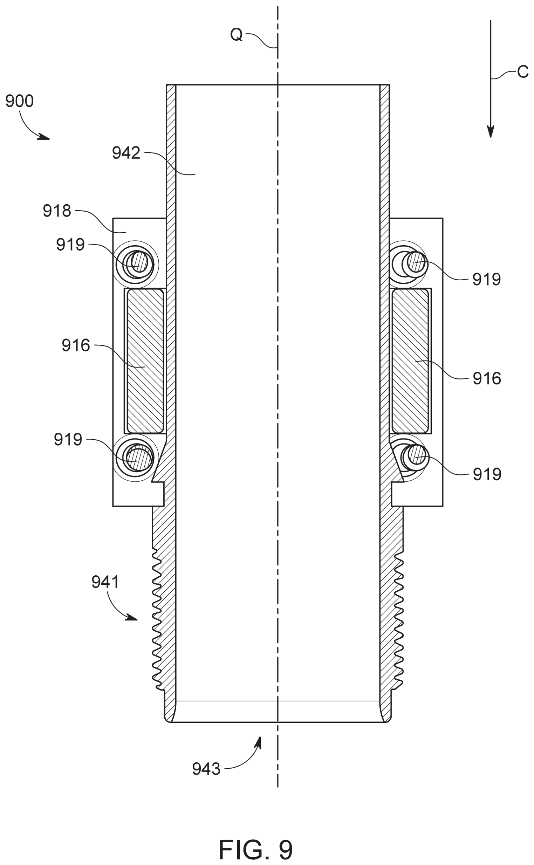

The first detecting element 820 and the second detecting element 822 are in communication with a processor 828 and a communication interface 832 and receive power from a power source 826. It should be appreciated that the first detecting element 820 and the second detecting element 822 and associated elements may be generally configured as described with reference to related elements in other examples described herein. For example, first detecting element 820 and the second detecting element 822 and associated elements may generally be configured as described with reference to the first detecting element 220 and the second detecting element 222 in FIGS. 2-4 and that these descriptions may also be applied to further embodiments described with reference to FIGS. 9-14 below. Although the embodiment of FIG. 8 is shown having the first detecting element 820 and the second detecting element 822, it should be appreciated that any number of detecting elements may be provided. For example, only the first detecting element 820 may be provided or a third detecting element (not shown) or yet further detecting elements (not shown) may be provided.

Turning now to FIG. 9, an example of a sectional view of a detectable element assembly 900 taken along the cut line 8-8 from the schematic view in FIG. 7 is provided. The detectable element assembly 900 may generally be used with other examples provided herein, for example with the position detection device 800 described with reference to FIG. 8. The example of FIG. 9 provides a detectable element 916 housed in a detectable element housing 918 and fixed at least in part with at least one detectable element fixture. As shown, a plurality of detectable element fixtures 919 are provided. The plurality of detectable element fixtures 919 may be threaded fasteners. For example, a clamshell configuration of the detectable element housing 918 may be held together by the plurality of detectable element fixtures 919.

The detectable element 916 of FIG. 9 is fixed relative to a body 942. For example, the detectable element 916 may be retained between the body 942 and the detectable element housing 918. The body 942 may be configured as a damper body as described above with reference to FIG. 8. As shown in FIG. 9, the body 942 includes a body opening 943, for example to receive a rod or other damping member, for example the rod 840 described with reference to FIG. 8. The body 942 depicted in FIG. 9 also includes a body attachment interface 941. The body attachment interface 941 may be used to locate various other components. For example, the body attachment interface may interface with a rod seal assembly (not shown) for sealing one or more damper components.

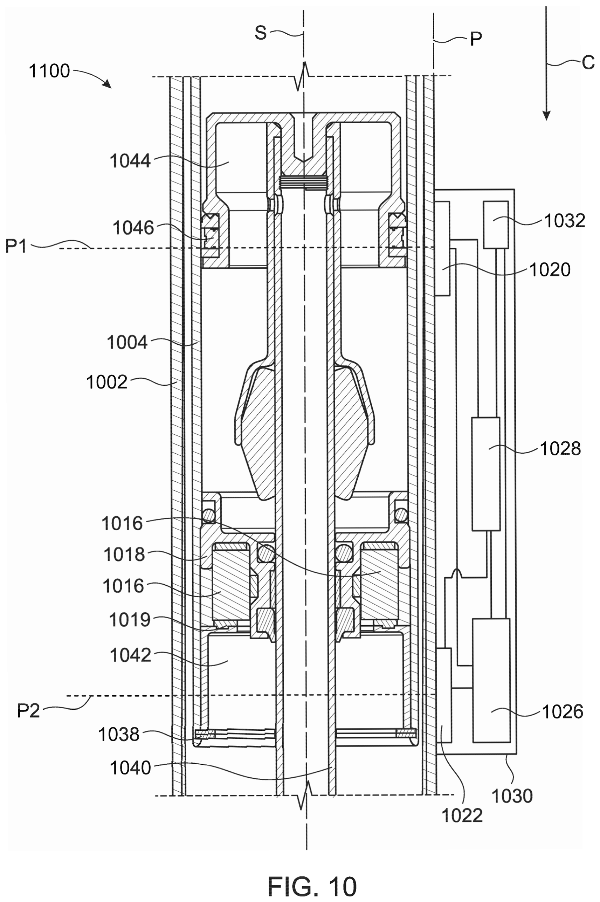

Turning now to FIG. 10, a second example of a sectional view of a position detection device 1000 taken along the cut line *10-10* from the schematic view in FIG. 7 is provided. It should be appreciated that the position detection device 1000 may generally apply any of the features or relationships described elsewhere herein with reference to other example position detection devices and associated elements. The position detection device 1000 may generally be provided in connection with an air spring translatable along a spring axis S. The spring axis S may generally represent an axis along which relative translation of components of the position detection device 1000 occurs and may generally conform to descriptions provided with reference to the axis T in FIGS. 2-4. As shown in FIG. 10, the position detection device 1000 may include a piston 1044 with a piston seal 1046 for sealing an air spring. For example, the piston seal 1046 may interface with an inner surface of a second leg 1004 to seal an air spring therein. The second leg 1004 is movable along the spring axis S relative to a first leg 1002 to compress or extend this air spring.

FIG. 10 further provides a detectable element 1016 fixed in an interior of the second leg 1004. The detectable element 1016 as shown is provided in a detectable element housing 1018 with a detectable element fixture 1019. The detectable element housing 1018 may generally contain the detectable element 1016. The detectable element fixture 1019 may be an elastomeric element. For example, the detectable element fixture 1019 may be provided to cushion or absorb shock to the detectable element 1016.

A body 1042 is further provided to at least in part retain the detectable element 1016 of FIG. 10. The body 1042 may be referred to as a spacer. The body 1042 as shown maintains the detectable element 1016 spaced apart from an end of the second leg 1004 in the compression direction C. The body 1042 may accordingly be used to achieve a desired position of the detectable element and/or to isolate the detectable element 1016 from any bottom out impact. The body 1042 is retained in the second leg 1004 by a detectable element limiter 1038. The detectable element limiter 1038 as shown may be a circlip or other suitable retaining element to retain the body 1042, the detectable element 1016, and other associated elements.

The example of FIG. 10 further includes a rod 1040 attached to the piston 1044. The rod 1040 is movable with the first leg 1002 relative to the detectable element 1016 and the second leg 1004. Accordingly, movement of the detectable element 1016 relative to the first leg 1002 may be used to determine movement of the piston 1044 relative to the second leg 1004 and thus compression and extension of the air spring.

One or more detecting elements may be provided to detect a position of the detectable element 1016. For example, FIG. 10 provides a first detecting element 1020 and a second detecting element 1022 in communication with a processor 1028 and a communication interface 1032, receiving power from a power source 1026. The first detecting element 1020 and the second detecting element 1022 may generally be provided external to the air spring enclosed by the first leg 1002 and the second leg 1004. As shown in the example of FIG. 10, the first detecting element 1020 and the second detecting element 1022 are enclosed in a detecting housing 1030 disposed on the first leg 1002. The first detecting element 1020 and the second detecting element are operable to detect a position of the detectable element across the detecting housing 1030, the first leg 1002, and the second leg 1004.

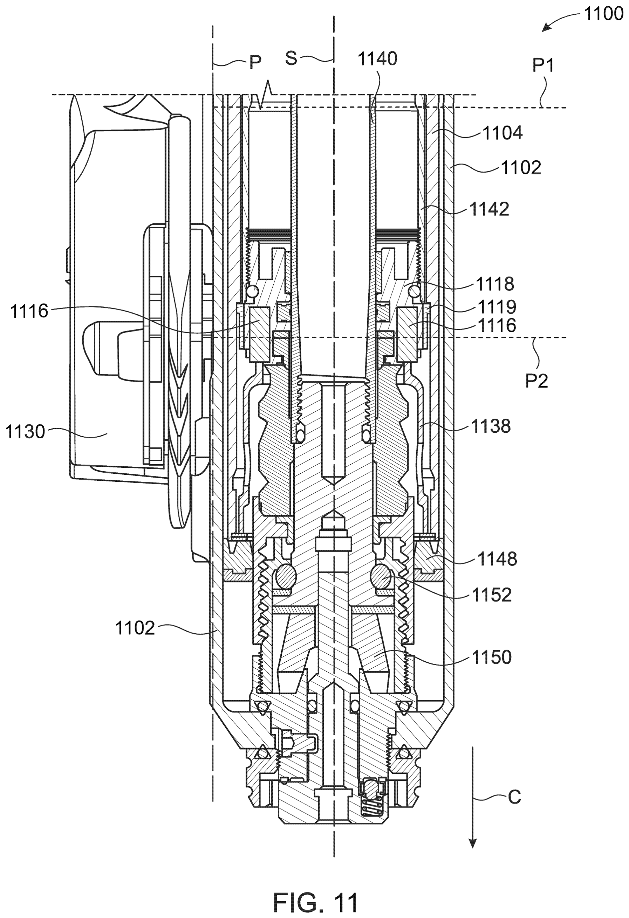

Turning now to FIG. 11, a third example of a sectional view of a position detection device 1100 taken along the cut line 11-11 from the schematic view in FIG. 7 is provided. It should be appreciated that the position detection device 1100 may generally apply any of the features or relationships described elsewhere herein with reference to other example position detection devices and associated elements. As shown in FIG. 11, the position detection device 1100 is provided with a combination brake and detecting housing 1130. The combination brake and detecting housing 1130 is provided fixed relative to a first leg 1102, movable relative to a second leg 1104. Although the present example of a combination brake and detecting housing 1130 is provided in connection with an air spring and is at least in part translatable along the spring axis S, it should also be appreciated that this example may be employed with damper embodiments of a position detection device as well.

The example of FIG. 11 provides a detectable element 1116 in a detectable element housing 1118. As shown, the detectable element 1118 is attached to a body 1142 which is in turn positionally fixed relative to the second leg 1104. The detectable element 1116 as shown is enclosed in the detectable element housing 1118 which is in turn located at least in part by a detectable element fixture 1119. The detectable element fixture 1119 as shown may be sized and shaped to fix the detectable element housing 1118 relative to the second leg 1102, for example with an interference fit. The detectable element fixture 1119 may be elastomeric to facilitate an interference fit and/or to cushion the detectable element 1116 from vibrations. A detectable element limiter 1138 is provided and may also be referred to as a spacer operable as described with reference to other air spring examples herein. For example, the detectable element limiter 1138 may interact with a bottom out limiter 1148 as shown in the example of FIG. 11 to define a bottom out position of the position detection device 1100.

Still referring to FIG. 11, a rod 1140 is connected with the first leg 1102. The rod 1140 may be rigidly connected with the first leg 1102 or may be at least in part isolated from the first leg 1102. For example, the rod 1140 may be vibrationally isolated from the first leg 1102 with one or more isolation features. As shown in the present example, a first isolator 1150 is provided below the rod 1140 in the compression direction C and a second isolator 1152 is provided above the rod 1140 in the compression direction C. The first isolator 1150 and the second isolator 1152 may cooperate to damp or otherwise control energy from suspension inputs to the first leg 1102 before transmission to the rod 1140. It should be appreciated that relative movement of the first leg 1102 and the second leg 1104 along the spring axis S would still occur regardless of input of the first isolator 1150 and the second isolator 1152. Accordingly, the position detection device 1100 described herein would be operable to measure changes in position of the second leg 1104 relative to the first leg 1102 facilitated by the first isolator 1150 and/or the second isolator 1152.

Although not visible in the view of FIG. 11, various further components of the position detection device 1100 may be provided. For example, the combined brake and detecting housing 1130 as described above may house various detectors and associated elements. In an example, the combined brake and detecting housing 1130 generally houses an arrangement of elements like those described with reference to the detecting housing 230 as described with reference to FIGS. 2-4 above. As shown in FIG. 11, the first detecting axis P1 and the second detecting axis P2 extending from the detecting plane P are indicative of detecting elements (not shown) operable to measure a position of the detectable element 1116.

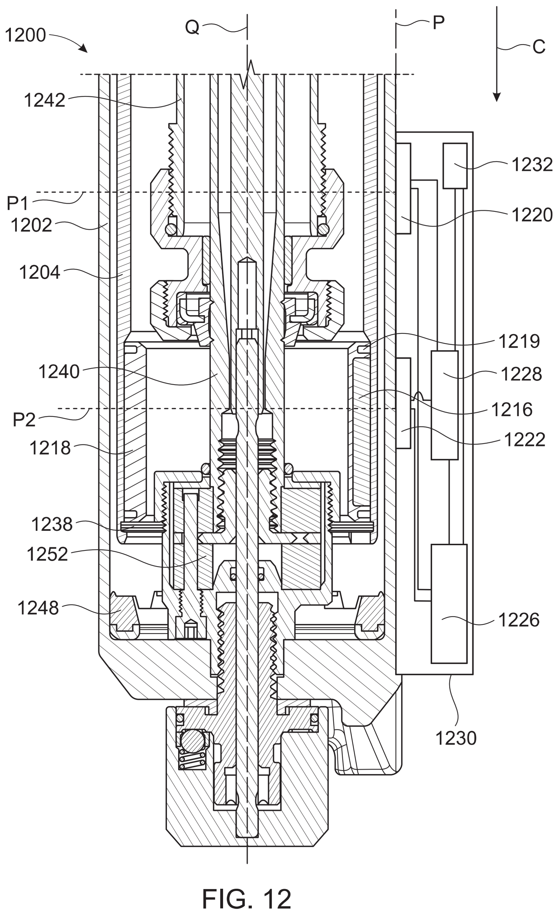

Turning now to FIG. 12, a fourth example of a sectional view of a position detection device 1200 taken along the cut line *12-12* from the schematic view in FIG. 7 is provided. It should be appreciated that the position detection device 1200 may generally apply any of the features or relationships described elsewhere herein with reference to other example position detection devices and associated elements. As shown in FIG. 12, various elements of the position detection device 1200 are translatable along the damper axis Q. For example, a first leg 1202 is movable along the damper axis Q relative to a second leg 1204. The second leg 1204 is translatable in the compression direction C relative to the first leg 1202 through a range of travel until travel is stopped with a bottom out limiter 1248.

In the example of FIG. 12, a detectable element 1216 is positionally fixed relative to the second leg 1204. The detectable element 1216 may be directly attached to the second leg 1204, for example with an adhesive mounting. Alternatively, as shown in the example of FIG. 12, the detectable element 1216 may be provided in a detectable element housing 1218. The detectable element housing 1218 is in turn affixed to the second leg 1204. As shown in the present example, a detectable element fixture 1219 is provided to fix the detectable element housing 1218 relative to the second leg 1204. The detectable element fixture 1219 may be an integral part of the second leg 1204, for example an axially inward protrusion relative to the damper axis Q. The detectable element fixture 1219 may also be configured as a removable element, for example a circlip or O-ring.

The second leg 1204 in the present example is movable along the damping axis Q relative to a rod 1240 attached to the first leg 1202. The rod 1240 is movable at least in part through a body 1242, which may also be referred to as an air spring body. The rod 1240 may be at least in part isolated from the first leg 1202. For example, the rod 1240 may be sprung and/or damped relative to the first leg 1202. As shown in the example of FIG. 12, an isolator 1252 may be provided to isolate the rod 1240 from impacts or other forces imparted to the first leg 1202. As shown, the isolator 1252 is operable to absorb forces in the compression direction C and opposite the compression direction C on the first leg 1202 in a force transmission path to the rod 1240. The isolator 1252 may be provided as a plurality of elements as shown with reference to the first isolator 1150 and the second isolator 1152 in FIG. 11. In the example of FIG. 12, the isolator 1252 is provided as a single component that at least in part retains the rod 1240 to control movement thereof in the compression direction C and opposite the compression direction C.

Still referring to FIG. 12, a detecting housing 1230 is provided external to the first leg 1202. The detecting housing 1230 generally houses one or more detectors for detecting a position of the detectable element 1216 internal to the first leg 1202. As shown in the present example, the detecting housing 1230 houses a first detecting element 1220 and a second detecting 1222, each in communication with a processor 1228, a power source 1226, and a communication interface 1232. The communication interface 1232 may be wired or wireless and may be used to transmit data and or command signals. For example, the communication interface 1232 may be used to transmit data indicative of position and/or to transmit command signals from processed position data, the command signals operative to command a change to suspension damping control, suspension spring control, or control of one or more other bicycle components.

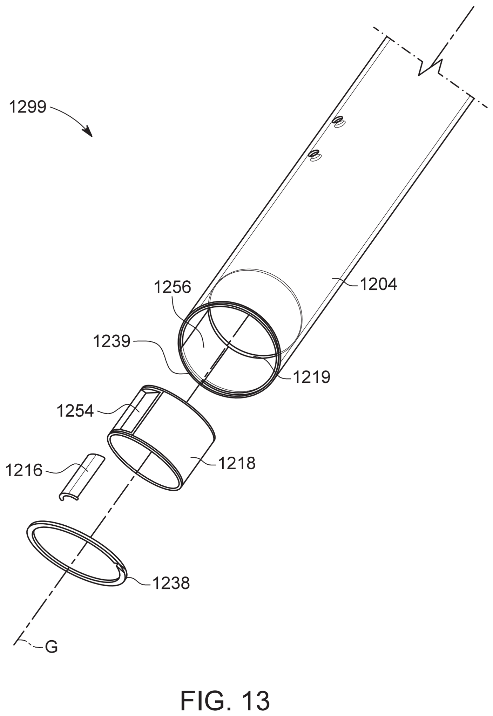

Turning now to FIG. 13, a partial exploded view of a detectable element assembly 1299 of the position detection device 1200 of FIG. 12 is provided. The detectable element assembly 1299 may generally describe the detectable element 1216 and associate elements fixed relative to the detectable element 1216. As shown in FIG. 13, the detectable element 1216 may be assembled along an assembly axis G with the detectable element housing 1218. A detectable element cavity 1254 is provided in the detectable element housing 1218, the detectable element cavity 1254 sized and shaped to accommodate the detectable element 1216. A detectable element clearance 1256 may be provided as a corresponding feature to the detectable element 1216. As shown in the present example, the detectable element clearance 1256 is provided in the second leg 1204. The detectable element clearance 1256 may cooperate with the detectable element housing 1218 to house the detectable element 1216. The detectable element clearance 1256 may also serve to reduce a wall thickness of the second leg 1204, for example to facilitate communication of a field of the detectable element 1216 across the second leg 1204. In an example, the detectable element clearance 1256 may be a broached feature in the second leg 1204.

Still referring to FIG. 13, a limiter recess 1239 is provided in the second leg 1204. The limiter recess 1239 may serve to control impact forces. For example, the limiter recess 1239 may be configured to deflect or otherwise absorb bottom out forces upon contact with the bottom out limiter 1248 as described with reference to FIG. 12 above. The limiter recess 1239 is shaped and sized to accommodate a detectable element limiter 1238. The detectable element limiter 1238 may be any suitable feature for retaining the detectable element 1216 relative to the second leg 1204. As shown in FIG. 13, the detectable element limiter 1238 may be a circlip, removable for disassembly or service.

Turning now to FIG. 14, a perspective view of a position detection device 1400 is provided. The position detection device 1400 may be employed with various bicycle components, for example the front fork 700 of FIG. 7, the front fork 108 of FIG. 1, or the rear suspension component 136 of FIG. 1. The position detection device of FIG. 14 may generally include features as described with relation to other embodiments, for example the position detection device 200 as described with reference to FIGS. 2-4. As shown in FIG. 14, the position detection device 1400 is provided with a detecting housing 1430. The detecting housing 1430 may be used to define an interior space of the position detection device 1400, for example with housed elements being disposed in an interior space of the detecting housing 1430. As shown, the detecting housing 1430 is provided independent of any further bicycle component, but it should be appreciated that the detecting housing 1430 may be integrated with various bicycle components, such as the front fork 700 of FIG. 7, the front fork 108 of FIG. 1, or the rear suspension component 136 of FIG. 1.

Still referring to FIG. 14, the position detection device 1400 further includes a housing mount 1431. The housing mount 1431 as shown is affixed to the detecting housing 1430, for example through one or more fasteners (not shown) and/or adhesive mounting. The housing mount 1431 may cooperate with the detecting housing 1430 to seal the interior space defined by the detecting housing 1430. It should be appreciated that in some embodiments the housing mount 1431 may be integral with detecting housing 1430, for example as a single unitary member.

The position detection device 1400 of FIG. 14 may be configured to mount to one or more components of a bicycle. For example, the position detection device 1400 may be sized and shaped complimentarily to one or more components. As described above, the position detection device 1400 may include the housing mount 1431 shown in FIG. 14. The housing mount 1431 as shown includes a mounting element 1472. The mounting element 1472 is shown as a contour complementary to a bicycle component. However, it should be appreciated that the mounting element 1472 may be provided as a fastener, adhesive, or other element for securing the position detection device 1400 to a bicycle component. As shown in FIG. 15, the mounting element 1472 includes a mounting surface 1474. The mounting surface 1474 is sized and shaped to mount to a bicycle component. In the example of FIGS. 14 and 15, the mounting surface 1474 is configured to mount with a generally tubular component or portion. For example, the mounting surface 1474 may be sized and shaped to conform with contours of a front fork of a bicycle such as the front fork 700 of FIG. 7 or the front fork 108 of FIG. 1.

Turning to FIG. 15, a rotated perspective view of the position detection device 1400 of FIG. 14 is provided. As shown in FIGS. 14 and 15, at least one alignment element may be provided. For example, a first alignment element 1476 may be provided to define or aid alignment of the position detection device 1400. In an embodiment, the first alignment element 1476 cooperates with a complimentary alignment element (not shown) on the bicycle component to aid alignment during installation. The first alignment element 1476 may serve to visually aid alignment and/or may physically interfere with misalignment positions. Turning to FIG. 15, a second alignment element 1477 may be provided. The second alignment element 1477 may cooperate with a complimentary alignment element (not shown) on the bicycle component. Additionally or alternatively, the first alignment element 1476 and the second alignment element 1477 may cooperate with each other and/or an alignment tool (not shown) to visually and/or physically aid alignment.

Referring to FIG. 14, the position detection device 1400 is shown to include a cover element 1435. The cover element 1435 may be provided for user access, for example to access an inside of a battery housing 1433. In an embodiment, for example where the detecting housing 1430 and the housing mount 1431 are unitary, the cover element 1435 may provide the only access to an interior of the detecting housing 1430. It should also be appreciated that the position detection device 1400 may also be provided as a sealed unit that is not openable for service. However, as shown in FIG. 14, the cover element 1435 may be removably coupled to the detecting housing 1430, for example with one or more of a fastener 1437.

Turning now to FIG. 16, a sectional view of the position detection device 1400 of FIG. 14 is provided across cut line 16-16. The position detection device 1400 may include one or more detecting elements, for example as described above with reference to FIGS. 2-4. In the example of FIG. 14, a first detecting element 1420, a second detecting element 1422, and a third detecting element 1424 are provided. As described above, for example with reference to FIGS. 2-4, the first detecting element 1420, the second detecting element 1422, and the third detecting element 1424 may generally be configured to provide location data of a remote detectable element (not shown), for example housed in a distinct bicycle component.

Still referring to FIG. 16, the first detecting element 1420, the second detecting element 1422, and the third detecting element 1424 are each in communication with a processor 1428. The processor 1428 is configured to process data from the first detecting element 1420, the second detecting element 1422, and the third detecting element 1424, for example to determine a position of a bicycle component as described elsewhere herein. A communication interface 1432 is provided in communication with the processor 1428. In the example shown, the processor 1428 includes a radio in communication with the communication interface 1432 which is provided as an antenna.

The first detecting element 1420, the second detecting element 1422, and the third detecting element 1424 may be positionally separated or otherwise isolated from various other components. For example, the first detecting element 1420, the second detecting element 1422, and/or the third detecting element 1424 may be isolated from components that may create electromagnetic interference. As shown in FIG. 16, the communication interface 1432 is provided on an opposite side of a printed circuit board (PCB) 1482 from the first detecting element 1420, the second detecting element 1422, and the third detecting element 1424. A power source 1426 is also provided on an opposite side of the PCB 1482 relative to the first detecting element 1420, the second detecting element 1422, and the third detecting element 1424. The power source 1426 may be a battery, for example a button or coin cell battery as shown. The PCB 1482 may inherently provide electromagnetic isolation from interference to the first detecting element 1420, the second detecting element 1422, and the third detecting element 1424 from the power source 1426 and/or the communication interface 1432. In an example, the PCB 1482 is configured to isolate the first detecting element 1420, the second detecting element 1422, and/or the third detecting element 1424 from electromagnetic interference, for example with metallic shielding. It should also be appreciated that further shielding elements may be provided. In an embodiment, the first detecting element 1420, the second detecting element 1422, and the third detecting element 1424 are located remotely from electromagnetically interfering elements.

Still referring to FIG. 16, a light element 1478 may be provided. The light element 1478 may serve as a visual indicator to a user, for example to confirm a status. In various examples, the light element 1478 is operable to confirm an operational status, a pairing status, and/or an error status. As shown in the present example, a lens 1480 may be provided with the light element 1478. The lens 1480 may be any light-transmissible element provided with the detecting housing 1430. For example, the detecting housing 1430 or a portion thereof may be transparent or translucent. The lens 1480 may also be integrated with the light element 1478 and/or the detecting housing 1430 or a portion thereof such as the cover element 1435 shown in FIG. 14. The lens 1480 may be configured to seal with the detecting housing 1430 to provide light transmission while retaining weather-resistant properties to protect elements internal to the detecting housing 1430.

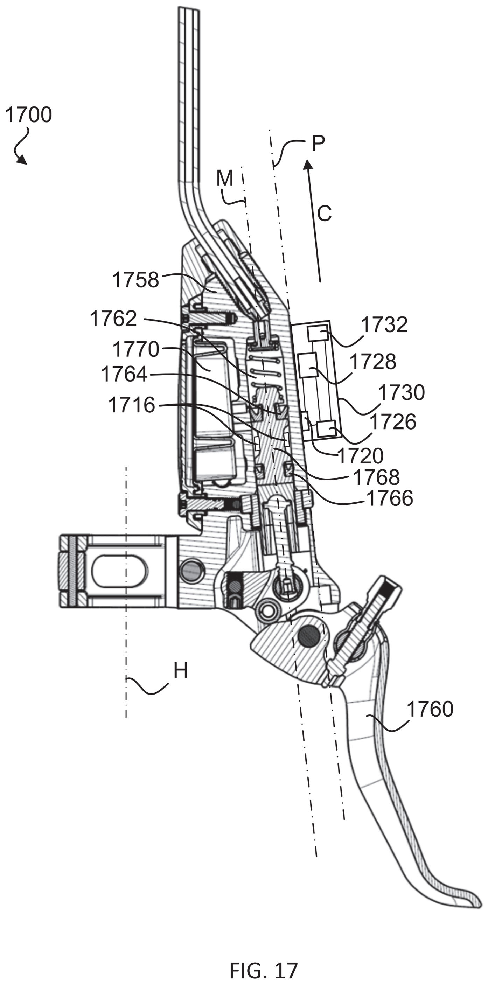

Turning now to FIG. 17, another example of a position detection device 1700 is provided. The position detection device 1700 described herein is provided in connection with a braking system. A detectable element 1716 may be fixed relative to various braking elements. For example, as shown in FIG. 17, the detectable element 1716 is attached to a braking element such as a master cylinder piston 1768. The master cylinder piston 1768 is translatable through a master cylinder 1762 along a cylinder axis M. Accordingly, the detectable element 1716, also referred to as a field generating element, is movable with the master cylinder piston 1768. Detections may be performed by a first detecting element 1720 or further detecting elements (not shown) relative to the detecting plane P. For example, detections may be performed parallel with and/or perpendicular to the detecting plane P as described with reference to the examples of FIGS. 2-4 above. The cylinder axis M may be aligned relative to the detecting plane P. For example, as shown in FIG. 17, the cylinder axis M may be parallel to the detecting plane P.

The example of FIG. 17 includes a brake body 1758 and a brake lever 1760 pivotably attached thereto and operable to control the master cylinder piston 1768. The master cylinder piston 1768 includes a first cylinder seal 1764 and a second cylinder seal 1766 each sealing between the master cylinder piston 1768 and the master cylinder 1762. As shown in the example of FIG. 17, the detectable element is disposed between the first cylinder seal 1764 and the second cylinder seal 1766 along the cylinder axis M. The master cylinder 1762 may be in constant or selective fluid communication with a reservoir 1770. In the example of FIG. 17, the master cylinder 1762 is in selective fluid communication with the reservoir, the selective communication controlled by the first cylinder seal 1764 and the second cylinder seal 1766. It should be appreciated that the detectable element 1716 may be adapted to contact with brake fluid. For example, the detectable element 1716 may be made of a material selective for non-corrosive interaction with brake fluid. It should also be appreciated that the detectable element 1716 may be sealed from contact with brake fluid.

As described above, the detectable element 1716 is detectable with at least the first detecting element 1720. The first detecting element 1720 may be provided in connection with the brake body 1758, for example being integrated therewith or housed therein. In the example of FIG. 17, the first detecting element 1720 is provided in a detecting housing 1730 external to the master cylinder 1762. The detecting housing 1730 may be at least in part integrated with the brake body 1758. As shown in the present example, the detecting housing 1730 may be mounted directly to the brake body 1758. The first detecting element 1720 is in communication with a processor 1728, a power source 1726, and a communication 1732, which may each be configured according to related examples described elsewhere herein.

The position detection device 1700 is mountable about a handlebar axis H to a handlebar (not shown) such as the handlebars 114 of FIG. 1. The handlebar axis H may be parallel to the detecting plane P. Alternatively, the handlebar axis H may be angled relative to the detecting plane P as depicted in the example of FIG. 17. Actuation of the brake lever 1760 from force generated by a rider from the handlebar axis H is operable to generate a braking force through movement of hydraulic fluid with the master cylinder piston 1768. Movement of the master cylinder piston 1768 in the compression direction C or opposite to the compression direction C is detectable through detection of the detectable element 1716 with the first detecting element 1720. A signal indicative of a position of the detectable element 1716 may then be transmitted with the communication interface 1732 to provide data on braking operation.

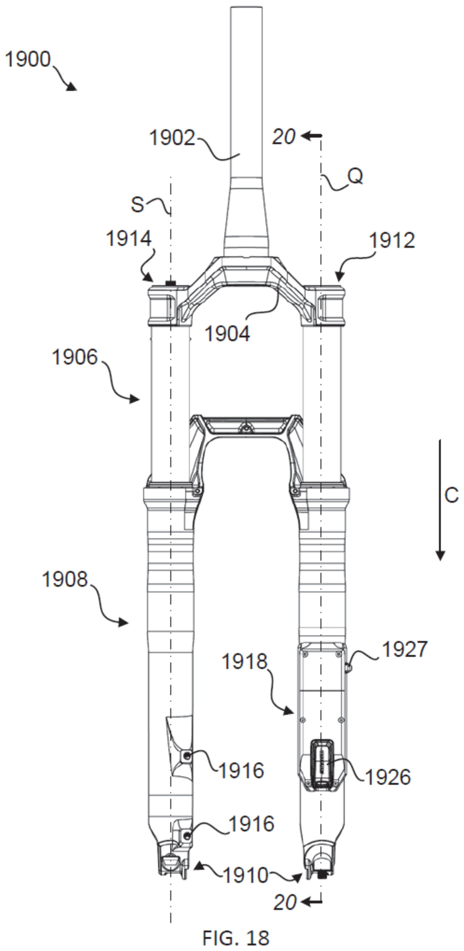

Turning now to FIG. 18, a rear view of a front fork 1900 is provided. The front fork 1900 may generally be used to employ any individual position detection device described herein or any combination thereof. As shown in FIG. 18, the front fork 1900 includes a steerer 1902 connected to a crown assembly 1904. The crown assembly 1904 is in turn connected to an upper assembly 1906, which is in turn connected to a lower assembly 1908. The lower assembly 1908 includes a wheel mounting portion 1910 and a brake mounting portion 1916 to control a front wheel (not shown).

The lower assembly 1908 and the upper assembly 1906 of FIG. 18 together define a damper portion 1912 and a spring portion 1914. For example, the spring portion 1914 may be disposed on one leg of the front fork 1900 and the damper portion 1912 may be disposed on another leg of the front fork 1900 as shown in FIG. 18. However, it should be appreciated that the spring portion 1914 and the damper portion 1912 may be combined in a single leg.

The example of FIG. 18 further provides a position detection housing 1918. The position detection housing 1918 may be sized and shaped to contain any number of position detection elements and related components as will be described in more detail below. The position detection housing 1918 may be at least in part made of a radio frequency transparent material. For example, the position detection housing 1918 may include a polymer, such as nylon, element to facilitate wireless transmissions between an interior of the position detection housing 1918 and an exterior. As shown in the example of FIG. 18, a user interface 1927 may also be provided on the position detection housing 1918, for example to facilitate a user powering on, powering off, initiating pairing, or otherwise commanding operation of a position detection device housed therein. The user interface 1927 may be configured to maintained a sealed environment of the position detection housing 1918. For example, the position detection housing 1918 may be sealed against the lower assembly 1908 and the user interface 1927 may be a sealed button mechanically or electrically communicating to the interior of the position detection housing.

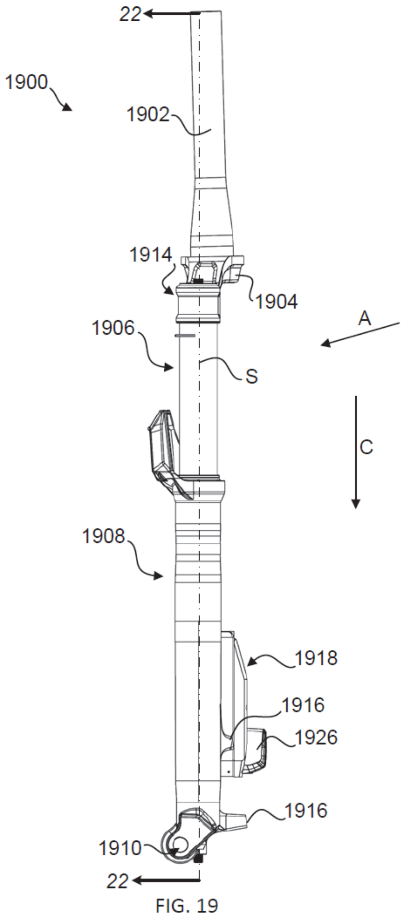

Turning now to FIG. 19, a side view of front fork 1900 is provided. As shown in FIG. 19, a power source 1926 may be provided external to the position detection housing 1918. For example, the power source 1926 may be a removable battery detachably attached to the position detection housing 1918. The power source 1926 and/or the position detection housing 1918 may include one or more sealing features to maintain a sealed environment of the position detection housing 1918 and/or the front fork 1900 generally.

As shown in the example of FIG. 19, the position detection housing 1918 may be disposed behind the front fork 1900 in relative to the riding direction A. This mounting location may facilitate protection of the position detection housing 1918 from obstacles and/or debris. Additionally or alternatively, this location may facilitate communication with other electronic components on a bicycle and/or provide aerodynamic advantages. As shown in FIG. 19, the power source 1926 may extend rearward from the position detection housing 1918 in a direction opposite to the riding direction A. Similar benefits to the locating of the position detection housing 1918 may be achieved by this locating of the power source 1926. Additionally, the power source 1926 may be easily removable and replaceable in such a location.

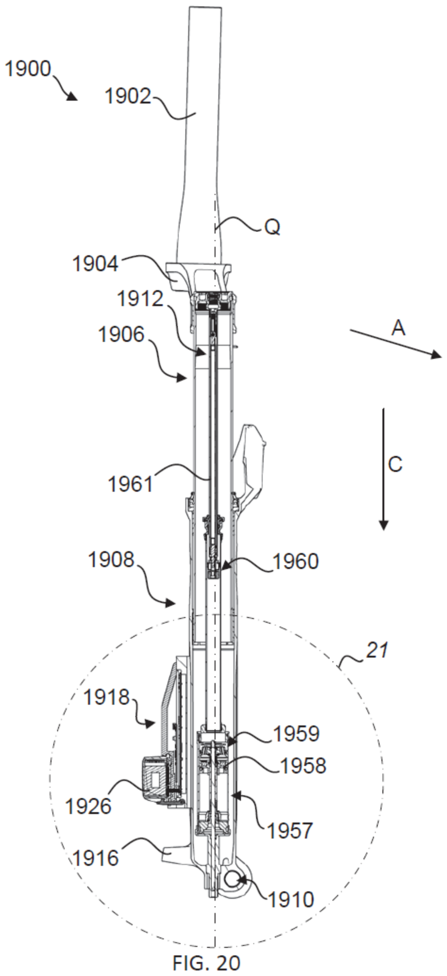

Turning now to FIG. 20, a sectional view of the front fork 1900, taken along cut line *20-20* in FIG. 18 is provided. Further detail of the damper portion 1912 is provided in FIG. 20 with this sectional view. As shown in FIG. 20, the damper portion 1912 includes a damper shaft 1961 at least in part controlling a compression assembly 1960 and extending between the upper assembly 1906 and the lower assembly 1908. The compression assembly 1960 generally controls restriction of flow when the front fork 1900 is compressed in the compression direction C and may be tunable to user dimensions and preferences. It should also be appreciated that the compression assembly 1960 could be configured to additionally or alternatively control rebound forces in a direction opposite the compression direction C.

Still referring to FIG. 20, the damper shaft 1961 is fixed relative to the upper assembly 1906 and movable relative to the lower assembly 1908. However, it should be appreciated that the opposite configuration could also be provided, for example relocating the position detection housing 1918 and associated components to the upper assembly 1906. However, in the present example of FIG. 20, housing a floating piston 1958 in the lower assembly 1908, the position detection housing 1918 is arranged to detect movement of the floating piston 1958 as will be described in greater detail below.

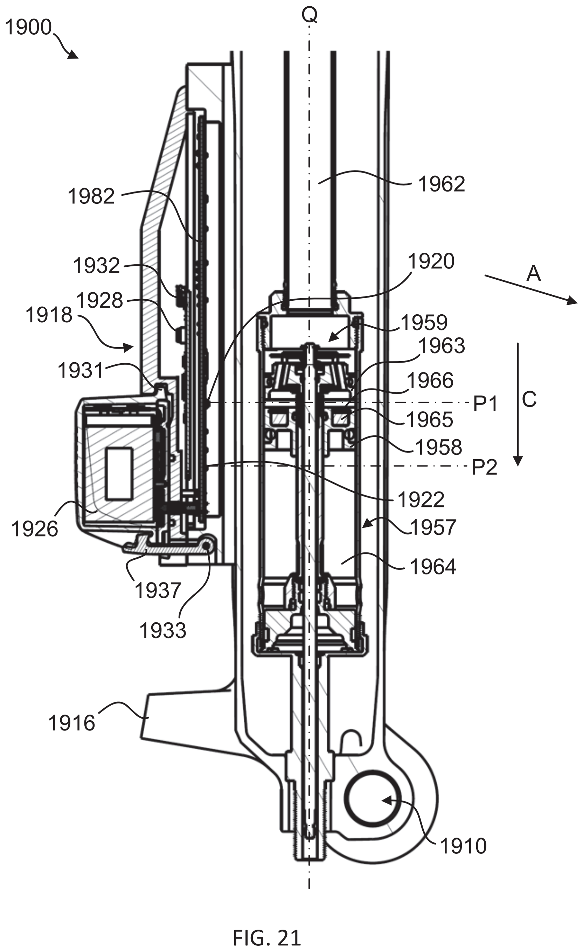

FIG. 21 is an enlarged sectional view of the front fork 1900 as indicated by callout *21* in FIG. 20. As shown in greater detail in FIG. 21, the floating piston 1958 is movably housed in a damper body 1957. In some examples, the portion of the damper body 1957 housing the floating piston 1958 may be referred to as an IFP housing, referencing the alternative "internal floating piston" designation of the floating piston 1958. The floating piston 1958 is movable responsive to compression and rebound of the front fork 1900, for example through movement of the damper shaft 1961 shown in FIG. 20. As shown in FIG. 21, fluid from a first oil chamber 1962 is movable, for example across a rebound assembly 1959, into a second oil chamber 1963. The rebound assembly 1959 may be a shim stack configuration as shown or may be otherwise provided. As fluid, for example suspension oil, is displaced into the second oil chamber 1963, the floating piston 1958 must also move. The floating piston 1958 is given freedom to move downward, for example along the damper axis Q, through compression of fluid in the air chamber 1964. The air chamber 1964 is pressurized to ensure the floating piston 1958 controls fluid behavior in the damper portion 1912, for example to prevent cavitation, while still allowing the floating piston 1958 to move in proportion to compression and rebound of the front fork 1900.

As described in the example above, the floating piston 1958 may be configured to move in proportion to movement of the front fork 1900. More specifically, the floating piston 1958 may move in direct proportion to relative movement between the upper assembly 1906 and the lower assembly 1908. That is, a constant or nearly constant ratio between movement of the upper assembly 1906 relative to the lower assembly 1908 and movement of the floating piston 1958 and movement of the damper body 1957. In some examples, this ratio may be about 10:1 suspension movement to IFP movement. Accordingly, position measurement of the floating piston 1958 may be correlated with position of the front fork 1900 in the compression direction C generally. It should also be appreciated that detection of the floating piston 1958 may be independently valuable, for example to determine if the front fork 1900 is being operated beyond a threshold or at all rather than being transported or moved.

Still referring to FIG. 21, one or more detection elements and detectable elements may be provided as described elsewhere herein. As shown, a detectable element 1965 is provided in the floating piston 1958. The detectable element 1965 is retained relative to the floating piston 1958 with a detectable element limiter 1966. As shown, the detectable element limiter 1966 is a circlip, but could be any retaining feature including adhesive or magnetic retaining features. The detectable element 1965 may be a permanent magnet or any other suitable detectable construction that may depend on the type of detecting element(s) implemented.

The example of FIG. 21 provides a first detecting element 1920 spaced apart from a second detecting element 1922. However, it should be appreciated that only the first detecting element 1920 may be employed, for example if adequate range and resolution is achieved given the relatively short travel of the floating piston 1958 along the damper axis Q relative to the relatively long travel of the front fork 1900 generally. In the present example, the first detecting element 1920 and the second detecting element 1922 are each disposed on a PCB 1982. The PCB 1982 may be configured with any number of elements as described elsewhere herein. As shown, the PCB 1982 includes a processor 1928 and a communication interface 1932. The communication interface 1932 may be a wireless radio, for example to receive and transmit wireless signals to an external device.

As shown in FIG. 21, the power source 1926 may be removably retained relative to the front fork 1900. For example, the power source 1926 may be removably attached to the position detection housing 1918 with a battery latch 1937. The present example provides a rotatable configuration of the battery latch 1937 mounted to the position detection housing 1918 with a latch pin 1933. A first end of the power source 1926 is selectively engaged by rotation of the battery latch 1937 and an opposite end of the power source 1936 engages the position detection housing 1918 with a power source locating feature, shown as a battery tab. It should be appreciated that in this and other examples, the power source 1926 may be interchangeable with one or more power sources on other bicycle components, for example gear changers, suspension controllers, seatposts, power meters, or any other electronic bicycle component.

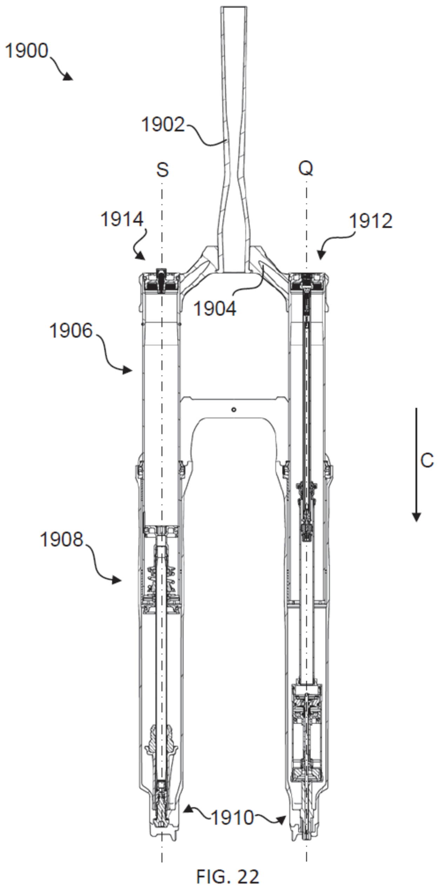

Turning now to FIG. 22, another sectional view of the front fork 1900 is provided as taken along cut line 22-22 in FIG. 19. The view of FIG. 22 provides a clearer look at the spring portion 1914 of the front fork 1900. It should be appreciated that other examples described herein may be combined with the described examples of the present front fork 1900. For example, the front fork 1900 may be modified with one or more fork chassis detecting and detectable elements. In such an example, data may be gathered representative of chassis travel (i.e., travel of the upper assembly 1906 relative to the lower assembly 1908) and representative of IFP travel (i.e. movement of the floating piston 1958 relative to the damper body 1957). Because such data would be expected to remain in a fixed and predictable relationship, any deviation may be used to indicate a fault condition, for example a loss of fluid in the damper portion 1912.

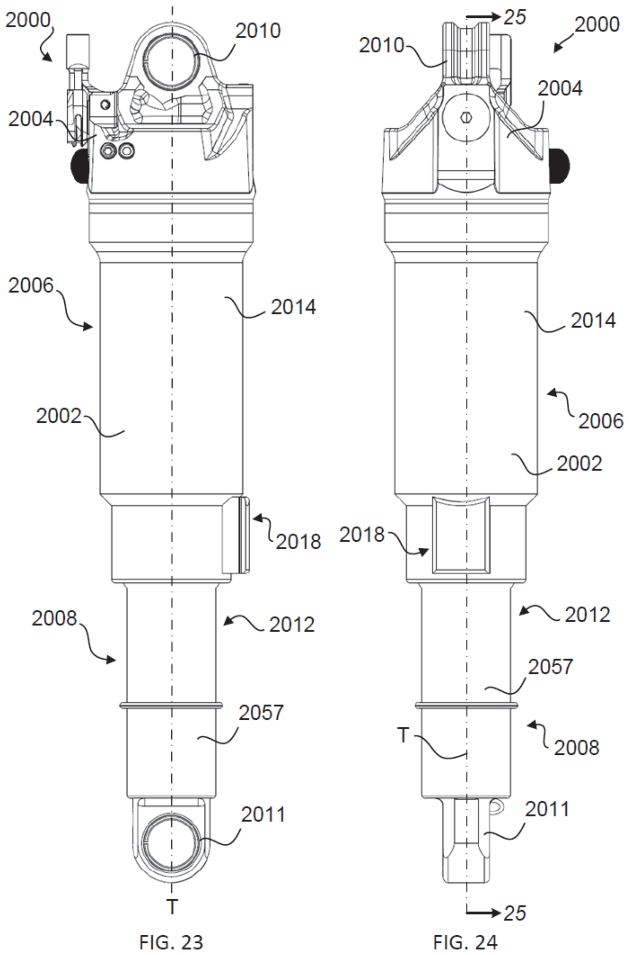

Turning now to FIG. 23, a side view of a shock 2000 that can employ any of the position detection devices described herein is provided. FIG. 24 is a second side view of the shock 2000 and will be described together with FIG. 23. The shock 200 generally includes a first mounting portion 2010 and a second mounting portion 2011. As shown, the first mounting portion 2010 and the second mounting portion 2011 are each of an eyelet configuration, but may be otherwise configured to mount to any type of bicycle frame element. Movement of the first mounting portion 2010 relative to the second mounting portion 2011 along an axis T provides suspension for a bicycle to which the shock 2000 can be attached.

In the present example, the first mounting portion 2010 is connected with a cap assembly 2004 as part of an outer assembly 2006. The second mounting portion 2011 is connected with a damper body 2057 as part of an inner assembly 2008. The inner assembly 2008 is telescopically movable within the outer assembly 2006 along the axis T. Each of the inner assembly 2008 and the outer assembly 2006 may be referred to separately as suspension elements. The outer assembly 2006 includes an air can 2002 into which the damper body 2057 may be received. Within the outer assembly 2006 is a spring portion 2014 adapted to resist compression of the shock 2000. Although the spring portion 2014 shown and described herein is an air spring configuration, it should be appreciated that a coil spring could also be employed in this example. A damper portion 2012 is also provided and adapted to control compression and extension of the shock 2000.

The example shown in FIGS. 23 and 24 further depicts a position detection housing 2018. The position detection housing 2018 may be generally configured as any other position detection housing described herein. As shown, the position detection housing 2018 is disposed near the damper body 2057 on the outer assembly 2006. As will be described in greater detail below, this example location of the position detection housing may facilitate compact packaging and reliable position detection.

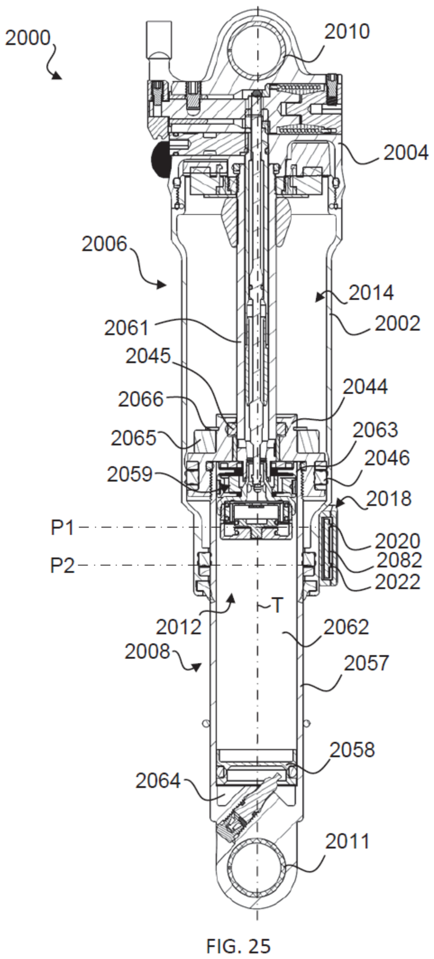

Turning now to FIG. 25, a sectional view of the shock 2000 taken along cut line 25-25 in FIG. 24 is provided. As shown in FIG. 25, a damper shaft 2061 is provided to in part control fluid movement between a first oil chamber 2062 and a second oil chamber 2063. As fluid is moved from the first oil chamber 2062 across a shim assembly 2059 and to the second oil chamber 2063, compressible fluid in an air chamber 2064 expands, moving a floating piston 2058 such that total volume between the first oil chamber 2062 and the second oil chamber 2063 remains constant as the damper shaft 2061 is retracted from this combined volume. The damper shaft 2061 is sealed by a sealhead inner seal 2045.

In the example of FIG. 25, a sealhead assembly 2044 is provided to retain the sealhead inner seal 2045 and a sealhead outer seal 2046. The sealhead inner seal 2045 seals the second oil chamber 2063 from the spring portion 2014 (shown as an air spring). The sealhead outer seal 2046 seals a positive spring volume from a negative spring volume in the spring portion 2014. The sealhead inner seal 2045 and the sealhead outer seal 2046 cooperate to allow the spring portion to compress air and serve as a suspension spring.

As shown in FIG. 25, a detectable element 2065 is provided with the sealhead assembly 2046. The detectable element 2065 may be a permanent magnet or any other suitable detectable element as described elsewhere herein. The detectable element 2065 is fixed relative to the sealhead with a detectable element limiter 2066, which may be a circlip or any other suitable fixing element described herein. The detectable element 2065 may also be integrally formed with, for example co-molded with, the sealhead assembly 2044.

Various position detection housings and their internal elements are described elsewhere herein and could be employed with the example of FIG. 25. As shown in the present example, a first detecting element 2020 and a second detecting element 2022 are provided, powered by an internal power source 2026. A communication interface 2032 and a processor 2028 are also provided internal to the position detection housing 2018 on a PCB 2082. In the example of FIG. 25, the first detecting element 2020 is operable to detect the position of the detectable element 2065 across at least one of the outer assembly 2006 and the inner assembly 2008.

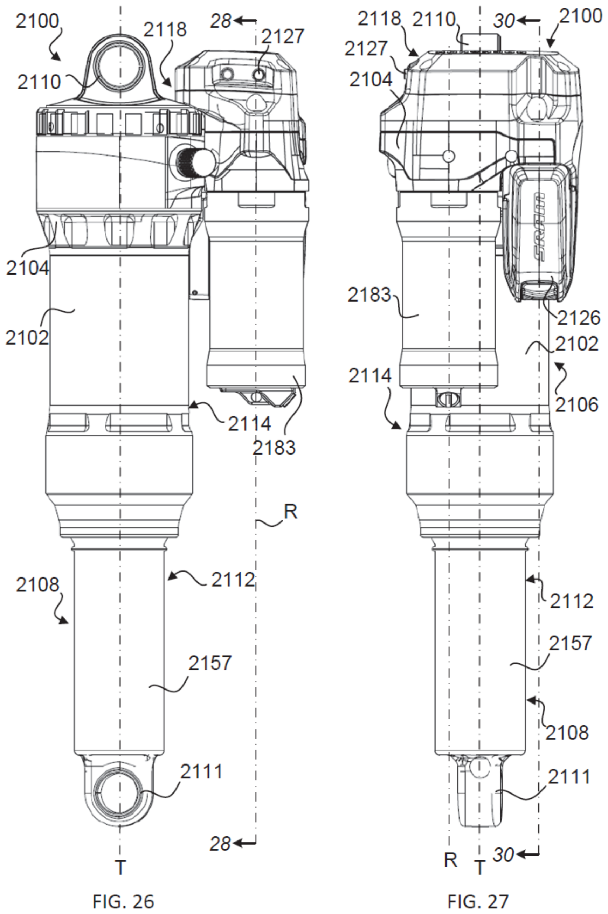

Turning now to FIG. 26, a side view of a shock 2100 that can employ any of the position detection devices described herein is provided. FIG. 27 is a second side view of the shock 2100 and will be described together with FIG. 26. The present example may generally be configured with respect to spring and damper components like the shock 2000 previously described. As shown in FIGS. 26 and 27, the shock 2100 is mountable with a first mounting portion 2110 and a second mounting portion 2111. The first mounting portion 2110 is connected to an outer assembly 2106 including a cap assembly 2104, an air can 2102, and a spring portion 2114. The second mounting portion 2111 is connected to an inner assembly including a damper body 2157 and a damper portion 2112.

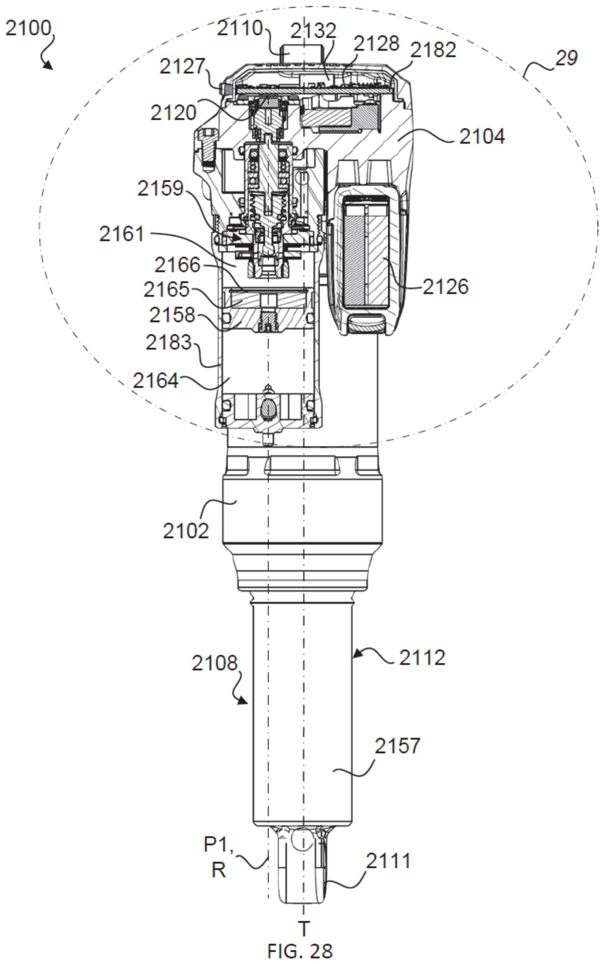

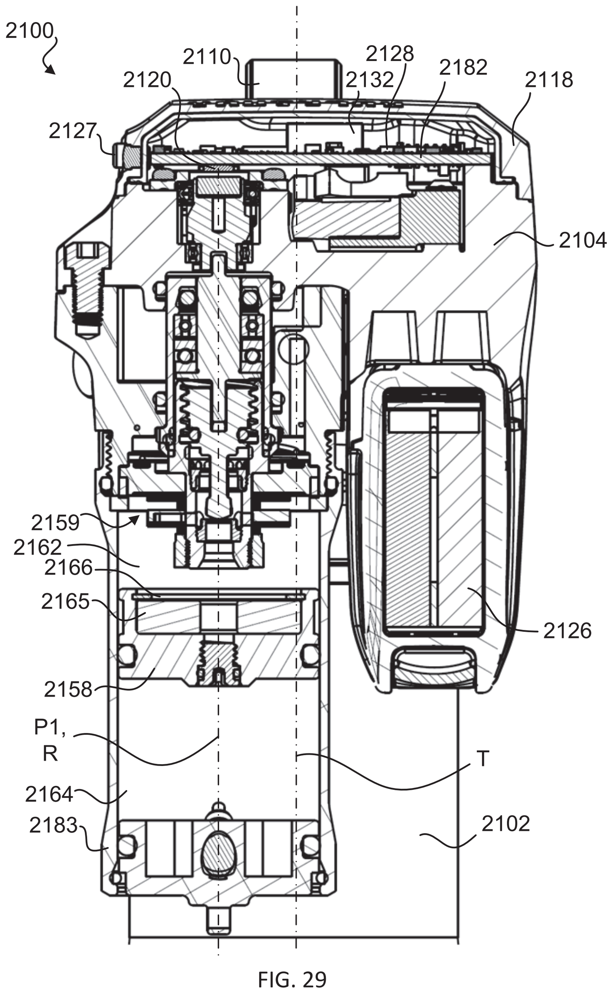

The example of FIG. 26 also provides a reservoir body 2183, sometimes referred to as an external reservoir or a piggyback. The reservoir body 2183 in the present example is configured to house an IFP as described elsewhere herein and more specifically to the present example with reference to FIGS. 28 and 29 below. The reservoir body 2183 as shown is connected to a first position detection housing 2118 adjacent to a power source 2126. As will be described below, one or more additional or alternative position detection housings may be provided, for example connected to the power source 2126 and adjacent the reservoir body 2183.

Turning now to FIG. 28, a sectional view of the shock 2100 taken along cut line *28-28* in FIG. 26 is provided. FIG. 29 is an enlarged sectional view as indicated by callout 29 in FIG. 28 and will be described together with FIG. 28. The views of FIGS. 28 and 29 show a floating piston 2158 housed within the reservoir body 2183. The floating piston 2158 moves relative to increases or decreases in a fluid volume of a first oil chamber 2162 and is pressure backed by gas pressure in an air chamber 2164. Oil movement across a shim assembly 2159 and into and out of the first oil chamber 2162 represents compression of the shock 2100. The floating piston 2158 accordingly can be used as a proxy for overall movement of the shock 2100 in a manner similar to that described with reference to the front fork 1900 above.

Still referring to FIG. 29, a detectable element is connected with the floating piston 2158, as shown retained with a detectable element limiter 2166. A first detecting element 2120 is provided on a PCB 2182 within the first position detection housing 2118. A processor 2128, a user interface 2127, and a communication interface 2132 are also provided as described elsewhere herein. The first detecting element 2120 as shown in this view has a first detecting axis P1 overlapping with but not concentric with a reservoir axis R representing travel of the floating piston 2158. Accordingly, the first detecting axis P1 may be parallel to travel of the floating piston 2158 along the reservoir axis R.

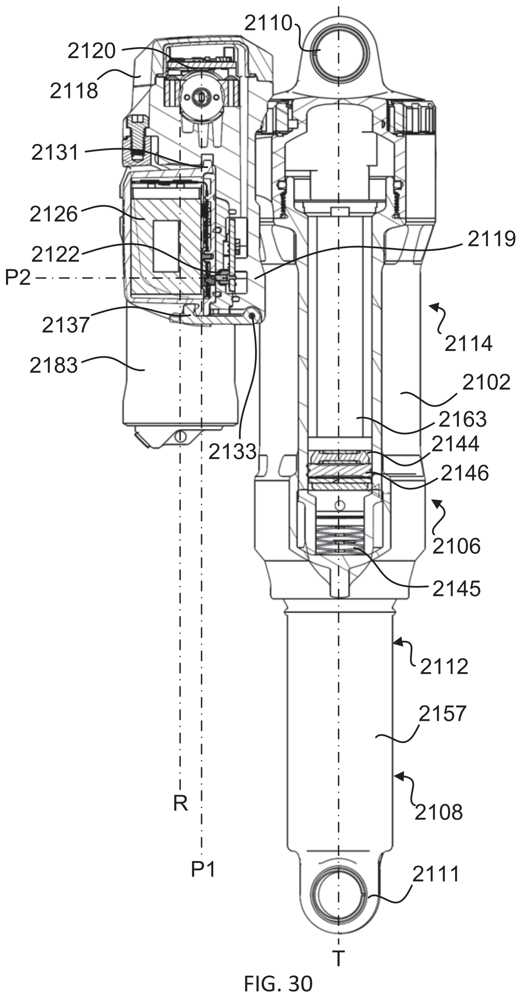

Turning now to FIG. 30, another sectional view of shock 2100 is provided as taken along cut line *30-30* in FIG. 27. As shown in FIG. 30, a second position detection housing 2119 may be provided. The second position detection housing 2119 may be in addition to the first position detection housing 2118 or an alternative thereto. In an example, the first position detection housing 2118 employs its first detecting element 2120 and the second position detection housing 2119 employs its second detecting element 2122 to cooperatively measure a position of the detectable element 2165. In this example, it is notable that the first detecting element 2120 has the first detecting axis P1 angularly offset, for example orthogonally offset, to a second detecting axis P1 of the second detecting element 2122.

The first detecting element 2120 and the second detecting element 2122, if employed together may share other elements such as the power source 2126, the communication interface 2132, and/or the processor 2128. Alternatively, additional such elements may be provided in duplicate for the second detecting element 2122. As shown in FIG. 30, the power source is secured adjacent to the second detecting element 2122 using a battery latch 2137, a latch pin 2133, and a power source locating feature 2131 similar to that described with reference to the front fork 1900 above.

In the partial sectional view of FIG. 30, a portion of a sealhead assembly 2144 is visible and includes a sealhead outer seal 2146. This configuration may generally be similar to that described with reference to the shock 2000 above. For example, the present example includes a second oil chamber 2163 sealed in part by the sealhead assembly 2144 to be moved across the shim assembly 2159 into the first oil chamber 2162 with compression of the shock 2100. Still with reference to FIG. 30, a coil spring 2145 is provided as a negative spring. It should be appreciated that a coil negative spring may be used in place of or in addition to an air negative spring just as coil and air positive springs may be interchanged.

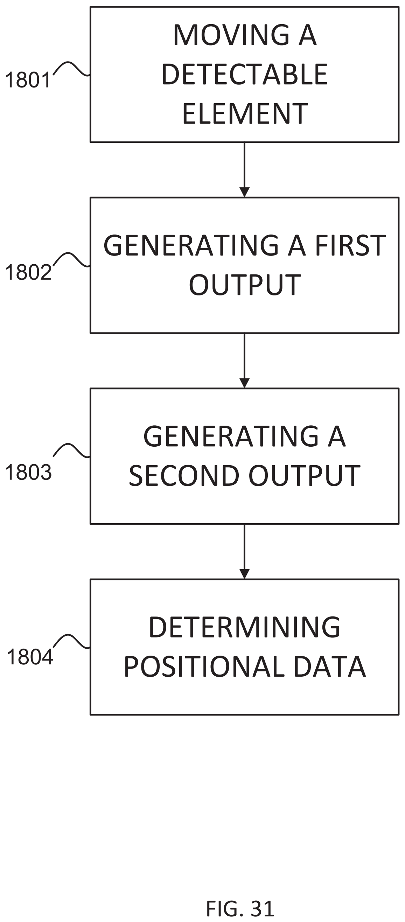

Turning now to FIG. 31, a flow chart describing a method of position detection is provided. It should be appreciated that the example methods described herein may be applied to any of the preceding examples of position detection device 200, 800, 1000, 1100, 1200, 1400, 1700. In 1801, a detectable element 216, 816, 916, 1016, 1116, 1216, 1716 is moved. For example, a detectable element 216, 816, 916, 1016, 1116, 1216, 1716 may be moved along a travel path throughout a travel range, for example translated along an axis G, M Q, S, T relative to one or more other elements. This movement may define an infinite number of positions. In an example, a detectable element 216, 816, 916, 1016, 1116, 1216, 1716 is movable between a first position and a second position.

Still referring to the method of FIG. 31, a first output is generated in 1802. The first output may be generated by a first detecting element 220, 820, 1020, 1220, 1420, 1720. The first output is indicative of movement of the detectable element 216, 816, 916, 1016, 1116, 1216, 1716 from the first position to the second position. In 1803, a second output is generated. The second output may be generated by a second detecting element 222, 822, 1022, 1222, 1422. The second output is different from the first output, for example being indicative of measurement from a different position. The second output is indicative of movement of the detectable element 216, 816, 916, 1016, 1116, 1216, 1716 from the first position to the second position.

The method of FIG. 31 proceeds to 1804 with determining positional data based on the first output and the second output. The determining may be performed with a processor 228, 828, 1028, 1228, 1428, 1728. The method may proceed to transmit processor outputs representative of positional data. For example, the processor 228, 828, 1028, 1228, 1428, 1728 may transmit, with a communication interface 232, 832, 1032, 1232, 1432, 1732 to a portable device, cloud storage, or various components of a bicycles for analysis or control as described elsewhere herein.

The embodiments described herein may be provided with any of the features and elements as shown and described. The illustrations of the embodiments described herein are intended to provide a general understanding of the structure of the various embodiments. The illustrations are not intended to serve as a complete description of all of the elements and features of apparatus and systems that utilize the structures or methods described herein. Many other embodiments may be apparent to those of skill in the art upon reviewing the disclosure. Other embodiments may be utilized and derived from the disclosure, such that structural and logical substitutions and changes may be made without departing from the scope of the disclosure. Additionally, the illustrations are merely representational and may not be drawn to scale. Certain proportions within the illustrations may be exaggerated, while other proportions may be minimized. Accordingly, the disclosure and the figures are to be regarded as illustrative rather than restrictive.

While this specification contains many specifics, these should not be construed as limitations on the scope of the invention or of what may be claimed, but rather as descriptions of features specific to particular embodiments of the invention. Certain features that are described in this specification in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations and/or acts are depicted in the drawings and described herein in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that any described program components and systems can generally be integrated together in a single software product or packaged into multiple software products.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, are apparent to those of skill in the art upon reviewing the description.

The Abstract of the Disclosure is provided to comply with 37 C.F.R. § 1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

It is intended that the foregoing detailed description be regarded as illustrative rather than limiting and that it is understood that the following claims including all equivalents are intended to define the scope of the invention. The claims should not be read as limited to the described order or elements unless stated to that effect. Therefore, all embodiments that come within the scope and spirit of the following claims and equivalents thereto are claimed as the invention.

Further aspects are provided by the subject matter of the following clauses:
A position detection device for a bicycle, the position detection device comprising: a bicycle component defining an interior and an exterior; a detectable element disposed in the interior of the bicycle component, the detectable element movable relative to the bicycle component; at least one detecting element disposed in the exterior of the bicycle component, the at least one detecting element operable to detect: a first position of the detectable element relative to the bicycle component, and a second position of the detectable element relative to the bicycle component, wherein the second position is different from the first position.

The position detection device of the preceding clause, wherein the at least one detecting element is operable to wirelessly detect the first position and the second position of the detectable element.

The position detection device of any of the preceding clauses, wherein the detectable element is a permanent magnet, and wherein the at least one detectable element is operable to detect a magnetic field of the detectable element.

The position detection device of any of the preceding clauses, wherein the at least one detecting element comprises a hall effect sensor.

The position detection device of any of the preceding clauses, wherein the at least one detecting element comprises: a first sensor; and a second sensor spaced apart from the first sensor.

The position detection device of any of the preceding clauses, wherein the first sensor is tuned to detect the first position of the detectable element and the second sensor is tuned to detect the second position of the detectable element.

The position detection device of any of the preceding clauses, wherein the detectable element is movable to an intermediate position between the first position and the second position, and wherein the first sensor and the second sensor are tuned to detect the intermediate position of the detectable element.

The position detection device of any of the preceding clauses, wherein the first position and the second position of the detectable element are spaced apart by at least eighty millimeters (80 mm).

The position detection device of any of the preceding clauses, wherein the at least one detecting element further comprises a third sensor, the third sensor tuned to detect a third position of the detectable element, wherein the second position is between the first position and the third position.

The position detection device of any of the preceding clauses, wherein the at least one detecting element is positionally fixed relative to the bicycle component.

The position detection device of any of the preceding clauses, wherein the bicycle component is a first telescopic suspension component, and wherein the detectable element is positionally fixed relative to a second telescopic suspension component movable within the first telescopic suspension component.

A position detection device for a bicycle, the position detection device comprising: a bicycle component defining an interior and an exterior; a field generating element disposed on the interior of the bicycle component and generating a field detectable in the exterior of the bicycle component; and at least one detecting element disposed in the exterior of the of the bicycle component operable to detect the field generated by the field generating element.

The position detection device of any of the preceding clauses, wherein the field generating element is movable along a travel path relative to the bicycle component between a first travel position and a second travel position, and wherein the at least one detecting element comprises: a first detecting element arranged to detect the field generating element at the first travel position; and a second detecting element arranged to detect the field generating element at the second travel position.

The position detection device of any of the preceding clauses, wherein the field generating element is permanent magnet.

The position detection device of any of the preceding clauses, wherein the at least one detecting element comprises a magnetometer.

The position detection device of any of the preceding clauses, wherein the at least one detecting element is operable to detect a first field magnitude along a first field axis and a second field magnitude along a second field axis and generate an output indicative of a travel position based on a combination of the first field magnitude and the second field magnitude.

The position detection device of any of the preceding clauses, wherein the bicycle component comprises a first tube, the first tube slidable relative to a second tube, wherein the field generating element is attached to the second tube.

The position detection device of any of the preceding clauses, wherein the first tube and the second tube together form a portion of a telescopic suspension arrangement.

The position detection device of any of the preceding clauses, further comprising a housing on the first tube, wherein the at least one detecting element is disposed in the housing.

The position detection device of any of the preceding clauses, wherein the field generating element is movable with a braking element.

The position detection device of any of the preceding clauses, further comprising a communication interface, the communication interface operable to transmit a signal responsive to detections made by the at least one detecting element.

A position detection device for a bicycle, the position detection device comprising: a first component; a detectable element disposed on the first component; a second component movable along an axis relative to the first component throughout a travel range; a first detecting element disposed on the second component, the first detecting element operable to detect the detectable element during a first portion of the travel range; and a second detecting element disposed on the second component, the second detecting element operable to detect the detectable element during a second portion of the travel range distinct from the first portion of the travel range.

A suspension component for a bicycle, the suspension component comprising: a first tube defining a first tube volume; a second tube disposed at least in part within the first tube volume, the second tube defining a second tube volume; a detectable element fixed relative to the second tube and disposed at least in part within the first tube volume; and at least one detecting element disposed external to the first tube volume and the second tube volume.

A method for detecting positions of a bicycle component, the method comprising: moving a detectable element along a travel path between a first position and a second position; generating, with a first detecting element, a first output based on movement of the detectable element from the first position to the second position; generating, with a second detecting element, a second output, different from the first output, based on movement of the detectable element from the first position to the second position; and determining, with a processor, positional data based on the first output and the second output.

## Claims

1. A position detection device for a suspension, the position detection device comprising:
a first suspension element defining an interior;
a second suspension element disposed at least in part in the interior of the first suspension element, the second suspension element movable relative to the first suspension element along an axis;
a detectable element disposed in the interior of the first suspension element, the detectable element fixed relative to the second suspension element and movable relative to the first suspension element; and
at least one detecting element disposed external to the interior of the first suspension element, the at least one detecting element operable to detect:
a first position of the detectable element relative to the first suspension element, and
a second position of the detectable element relative to the first suspension
element, wherein the second position is different from the first position.

2. The position detection device of claim 1, wherein the at least one detecting element is operable to wirelessly detect the first position and the second position of the detectable element.

3. The position detection device of claim 2, wherein the detectable element is a permanent magnet, and wherein the at least one detecting element is operable to detect a magnetic field of the detectable element, wherein as an optional feature the at least one detecting element comprises a hall effect sensor.

4. The position detection device of one of the preceding claims, wherein the at least one detecting element comprises:
a first sensor; and
a second sensor spaced apart from the first sensor.

5. The position detection device of claim 4, wherein the first sensor is tuned to detect the first position of the detectable element and the second sensor is tuned to detect the second position of the detectable element.

6. The position detection device of claim 5, wherein the detectable element is movable to an intermediate position between the first position and the second position, and wherein the first sensor and the second sensor are tuned to detect the intermediate position of the detectable element,
wherein as an optional feature the first position and the second position of the detectable element are spaced apart by at least eighty millimeters (80 mm).

7. The position detection device of one of claims 5 or 6, wherein the at least one detecting element further comprises a third sensor, the third sensor tuned to detect a third position of the detectable element, wherein the second position is between the first position and the third position.

8. A position detection device for a bicycle, the position detection device comprising:
a bicycle component defining an interior;
a field generating element disposed on the interior of the bicycle component and generating a field detectable external of the interior of the bicycle component; and
at least one detecting element disposed external of the interior of the of the bicycle component, the at least one detecting element operable to detect the field generated by the field generating element.

9. The position detection device of claim 8, wherein the field generating element is movable along a travel path relative to the bicycle component between a first travel position and a second travel position, and wherein the at least one detecting element comprises:
a first detecting element arranged to detect the field generating element at the first travel position; and
a second detecting element arranged to detect the field generating element at the second travel position,
wherein as an optional feature the field generating element is permanent magnet.

10. The position detection device of one of claims 8 or 9, wherein the at least one detecting element comprises a magnetometer.

11. The position detection device of claim 10, wherein the at least one detecting element is operable to detect a first field magnitude along a first field axis and a second field magnitude along a second field axis and generate an output indicative of a travel position based on a combination of the first field magnitude and the second field magnitude.

12. The position detection device of one of claims 8 to 11, wherein the bicycle component comprises a first tube, the first tube slidable relative to a second tube, wherein the field generating element is attached to the second tube,
wherein as an optional feature the first tube and the second tube together form a portion of a telescopic suspension arrangement.

13. The position detection device of claim 12, further comprising a housing on the first tube, wherein the at least one detecting element is disposed in the housing.

14. The position detection device of one of claims 8 to 13, wherein the field generating element is movable with a braking element,
wherein the detection device further comprises as an optional feature a communication interface, the communication interface operable to transmit a signal responsive to detections made by the at least one detecting element.

15. A position detection device for a bicycle, the position detection device comprising:
a first component;
a detectable element disposed on the first component;
a second component movable along an axis relative to the first component throughout a travel range;
a first detecting element disposed on the second component, the first detecting element operable to detect the detectable element during a first portion of the travel range; and
a second detecting element disposed on the second component, the second detecting element operable to detect the detectable element during a second portion of the travel range distinct from the first portion of the travel range.
